# EUROPEAN PATENT SPECIFICATION

(11) **EP 3 419 055 B1**
(45) Date of publication and mention of the grant of the patent: **16.12.2020**
(21) Application number: 18187644.2
(22) Date of filing: 27.06.2013
(51) Int. Cl.: H01L 29/40, H01L 29/778, H01L 21/335, H03K 17/081

(54) **SWITCHING DEVICE WITH CHARGE DISTRIBUTION STRUCTURE**
SCHALTVORRICHTUNG MIT LADEVERTEILUNGSSTRUKTUR
DISPOSITIF DE COMMUTATION COMPORTANT UNE STRUCTURE DE RÉPARTITION DE CHARGE

(30) Priority: 29.06.2012 US 201213537407; 29.06.2012 US 201213537443
(43) Date of publication of application: 26.12.2018
(62) Divisional of application: 13737058.1
(73) Proprietor: Power Integrations, Inc., San Jose, CA 95138 (US)
(72) Inventor: KUDYMOV, Alexey, Ringoes, NJ New Jersey 08551 (US)
(74) Representative: Fish & Richardson P.C.

(56) References cited:
- CN-A- 101 320 751
- A. NAKAJIMA ET AL.: "Novel field plate structure of AlGaN/GaN HEMTs", PHYSICS STATE SOLID C, vol. 4, no. 7, 2007, pages 2736-2739, XP002712729, Weinheim DOI: 10.1002/pssc.200674876

## Description

### Background

This invention is related to semiconductor devices. In particular, the invention is related to high voltage heterostructure field effect transistors (HFETs) that operate as switches and power switches.

High voltage semiconductor switches are key components in electronic circuits for power conversion. Examples of these applications includepower supplies for electronic equipment, drives for electric motors, and inverters for solar cells.

A power switch has an on state that allows the device to conduct current, and an off state that prevents the device from conducting current. When in the on state, a power switch may conduct tens or hundreds of amperes while the voltage across the switch is less than one volt. When in the off state, the power switch typically must withstand hundreds or thousands of volts while conducting substantially zero current. The voltage that the device can withstand in the off state while conducting no more than a given small value of current is sometimes referred to as the breakdown voltage.

It is usually desirable that the transition between the two states be as fast as possible because during the transition there may be relatively high current in the switch at the same time there is relatively high voltage across the switch. The presence of relatively high current and high voltage at the same timerepresents a loss of energy that at best is undesirable and at worst could destroy the switch.

High voltage HFETs are attractive for use as power switches primarily because they can change states substantially faster than other semiconductor switches that conduct the same currentsat similar voltages. The materials used in the construction of HFETs also allow them to operate at higher temperatures than transistors that use traditional silicon-based technology.

A major problem with the fabrication of HFETs for power switches is that existing techniques produce devices with breakdown voltages that are substantially below the values that are theoretically possible. In addition, it is difficult to predict how the application of known techniques such as the use of field plates influences the breakdown voltage. As such, the design of devices for specific characteristics is difficult and time-consuming, requiring the application of cut-and-try methods to fabricate and test hardware rather than the use of computer modeling.

A solution is required that will allow power HFETs to be designed in less time for desired performance with predictable breakdown voltage.

CN 101320751 (A) describes a HEMT component and a method for manufacturing the HEMT component. The HEMT component comprises: a semiconductor layer on a substrate; an isolated layer on the semiconductor layer; a source electrode and a drain electrode which contact with the semiconductor layer; and a grid and at least one floating gate on the isolated layer, wherein the grid and the floating gate have a double-layer structure, wherein the upper layer is a conducting layer and the lower layer is a first medium layer.

Nakajima et al. (Phys. Stat. Sol. C 4 (7) p. 2736-2739) describe a field plate structure of AlGaN/GaN HEMTs.

### Brief Description of the Figures

Non-limiting and non-exhaustive embodiments of the present invention are described with reference to the following figures, wherein like reference numerals refer to like parts throughout the various views unless otherwise specified.
Fig. 1 is a cross-section of an example semiconductor device showing the components of an example charge distribution structure.
Fig. 2 isa cross-section of an example semiconductor device showing capacitance between components of an example charge distribution structure and an active layer in the semiconductor device.
Fig. 3A is schematic diagram of an example circuit that includes a semiconductor device with a charge distribution structure under the conditions of constant voltage and current.
Fig. 3B is a graph that shows relative magnitudes of constant voltage and current in the example circuit of Fig. 3A.
Fig. 4 is a cross-section of a portion of the example semiconductor device in the circuit of Fig. 3A generally illustrating the distribution of charge and capacitance for the conditions depicted in the graph of Fig. 3B.
Fig. 5A is a schematic diagram of another example circuit that includes a semiconductor device with a charge distribution structure under the conditions of dynamic voltage and current.
Fig. 5B is a graph that shows relative magnitudes of dynamic voltage and current in the example circuit of Fig. 5A.
Fig. 6 is a cross-section of a portion of the example semiconductor device in the circuit of Fig. 5A generally illustrating the distribution of charge and capacitance for the conditions depicted in the graph of Fig. 5B.
Fig. 7A is an illustration in a perspective view that shows the relative positions of various parts and features of an example semiconductor device that includes a charge distribution structure.
Fig. 7B is an illustration in a different perspective view of the example semiconductor device in Fig. 7A illustrating the relative positions of other parts and features not visible in the view of Fig. 7A.
Fig. 8 is an example flow diagram illustrating generally a sample flow of operations in a process to construct the example semiconductor device illustrated in Fig. 7A and Fig. 7B with a charge distribution structure.
Fig. 9A is an illustration in a perspective view that shows the relative positions of various parts and features of another example semiconductor device that includes a charge distribution structure.
Fig. 9B is an illustration in a different perspective view of the example semiconductor device in Fig. 9A illustrating the relative positions of other parts and features not visible in the view of Fig. 9A.
Fig. 10 is an example flow diagram illustrating generally a sample flow of operations in a process to construct the example semiconductor device illustrated in Fig. 9A and Fig. 9B with a charge distribution structure.
Fig. 11 is an electrical schematic that shows an equivalent circuit of an example static discharge system.
Fig. 12 is an electrical schematic that shows an equivalent circuit illustrating the general configuration of an example static discharge system.
Fig. 13 is a cross section of a semiconductor structure that shows transistors of an example static discharge system.
Fig. 14 is a top view of a semiconductor structure that shows transistors of an example static discharge system and a portion of an example high voltage power HFET with an example charge distribution structure.
Fig. 15A is an illustration in a perspective view that shows relative positions of various parts and features of an example semiconductor device that includes a static discharge system and a portion of a power HFET.
Fig. 15B is an illustration in a different perspective view of the example semiconductor device in Fig. 15A illustrating the relative positions of other parts and features not visible in the view of Fig. 15A.
Fig. 16A is an illustration in perspective view of the example semiconductor device in Fig. 15A with passivation removed to reveal metal that is not visible in the illustration of Fig. 15A.
Fig. 16B is an illustration in a different perspective view of the example semiconductor device in Fig. 15B illustrating the relative positions of other parts and features not visible in the view of Fig. 15B.
Fig. 17 is an example flow diagram illustrating generally a sample flow of operations in a process to construct the example semiconductor device illustrated in Fig. 15A and Fig. 15B that includes a static discharge system.
Fig. 18A is an illustration in a perspective view that shows relative positions of various parts and features of another example semiconductor device that includes a static discharge system and a portion of a power HFET.
Fig. 18B is an illustration in a different perspective view of the example semiconductor device in Fig. 18A illustrating the relative positions of other parts and features not visible in the view of Fig. 18A.
Fig. 19A is an illustration in perspective view of the example semiconductor device in Fig. 18A with passivation removed to reveal metal that is not visible in the illustration of Fig. 18A.
Fig. 19B is an illustration in a different perspective view of the example semiconductor device in Fig. 18B illustrating the relative positions of other parts and features not visible in the view of Fig. 18B.
Fig. 20 is an example flow diagram illustrating generally a sample flow of operations in a process to construct the example semiconductor device illustrated in Fig. 18A and Fig. 18B that includes a static discharge system and a portion of a power HFET.

### Description

In the following description, numerous specific details are set forth in order to provide a thorough understanding of the present invention. It will be apparent, however, to one having ordinary skill in the art that the specific detail need not be employed to practice the present invention. In other instances, well-known materials or methods have not been described in detail in order to avoid obscuring the present invention.

Reference throughout this specification to "one embodiment", "an embodiment", "one example" or "an example" means that a particular feature, structure or characteristic described in connection with the embodiment or example is included in at least one embodiment of the present invention. Thus, appearances of the phrases "in one embodiment", "in an embodiment", "one example" or "an example" in various places throughout this specification are not necessarily all referring to the same embodiment or example. Furthermore, the particular features, structures or characteristics may be combined in any suitable combinations and/or subcombinations in one or more embodiments or examples. Particular features, structures or characteristics may be included in an integrated circuit, an electronic circuit, a combinational logic circuit, or other suitable components that provide the described functionality. In addition, it is appreciated that the figures provided herewith are for explanation purposes to persons ordinarily skilled in the art and that the drawings are not necessarily drawn to scale.

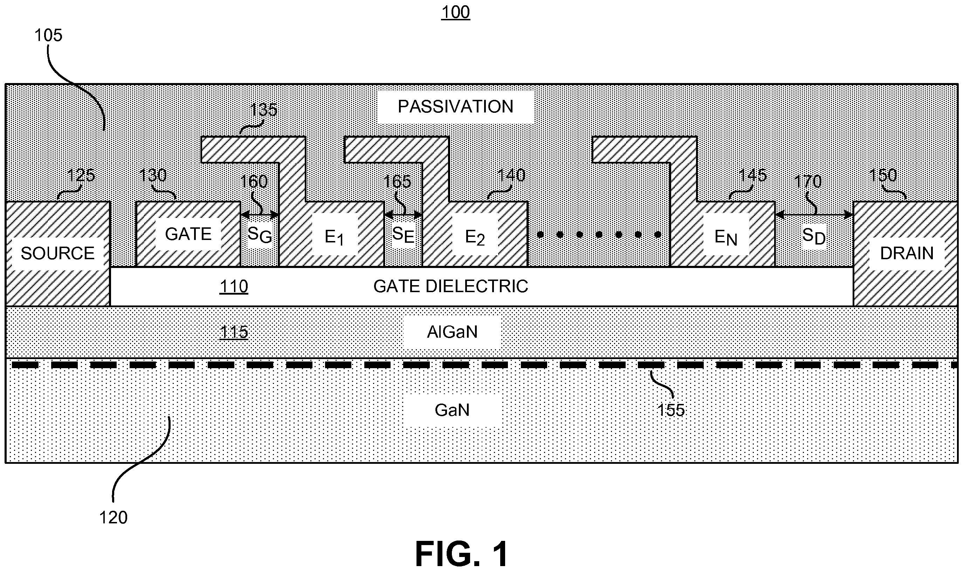

Fig. 1 shows the salient features of an example semiconductor device. In particular, Fig. 1, which is not drawn to scale, is a cross-sectional view 100 through one part of a high voltage heterostructure field effect transistor (HFET). The example HFET illustrated in Fig. 1 comprises a first active layer 120 and a second active layer 115.

The first active layer 120 is typically disposed over a substrate (not shown in Fig. 1) that may be formed from various materials such as sapphire (Al₂O₃), silicon (Si), or silicon carbide (SiC) as is known in the art. Various techniques of fabrication may call for layers of other materials to be disposed between the substrate and the first active layer 120to facilitate the construction of the device.

The first active layer 120 in the example of Fig. 1 is comprised of gallium nitride (GaN). In other examples, differentsemiconductor materials containing nitride compounds of other elements from Group III of the Periodic Table of the Elements may comprise the first active layer 120.

The second active layer 115 in the example of Fig. 1 is comprised of aluminum gallium nitride (AlGaN). In other examples, different Group III nitride semiconductor materials such aluminum indium nitride (AlInN) and aluminum indium gallium nitride (AlInGaN) may comprise the second active layer 115. The material of the second active layer 115 may be a non-stoichiometric compound. In such materials, the ratios of the elements are not easily represented by ordinary whole numbers. For example, the second active layer 115 may be a non-stoichiometric compound of a Group III nitride semiconductor material such as AlxGai-xN where 0<X<1.

In the example of Fig. 1, a conductive source contact 125, a conductive gate contact 130, and a conductive drain contact 150 are disposed over the second active layer 115. Also shown in the sample of Fig. 1 are conductive componentsE₁135, E₂140, and E_{N}145 of a charge distribution structure that will be described in further detail later in this disclosure.The conductive components E₁ 135, E₂ 140, and E_{N} 145 may be formed from an electrically conducting material or materials such as one or more metals, heavily doped semiconductors, and the like.

In the example HFET of Fig. 1, the componentsE₁135, E₂140, and E_{N}145 of the charge distribution structure are located between the gate contact 130 and the drain contact 150. In the example of Fig. 1, the component E₁ 135 of the charge distribution structure is laterally spaced from the gate contact 130 by a first distance S_{G} 160. In the example of Fig. 1, the component E_{N} 145of the charge distribution structure is laterally spaced from the drain contact 150 by a second distance S_{D} 170. In the example of Fig. 1, the second distance S_{D} 170 is greater than the first distance S_{G} 160. The spacing between any two components S_{E} 165 of the charge distribution structure may be selected to achieve desired performance characteristics as described later in this disclosure.

While the example HFET of Fig. 1 shows three conductive components forming the charge distribution structure, any suitable number of conductive components may be employed, including, in some cases, a single conductive component. Moreover, as shown in Fig. 1, in those implementations where multiple conductive components are employed, the conductive components may define a metal grid formed from a series of periodically repeating components which are identical to one another. In other examples, the conductive components need not periodically repeat, nor must they all be identical to one another.Rather, different conductive components may have different configurations, dimensions, and so on.

Also in the example HFET of Fig. 1, a gate dielectric layer 110 separates the gate contact 130 and the componentsE₁135, E₂140, and E_{N}145 of the charge distribution structure from the second active layer 115.A passivation layer 105 of a dielectric material is disposed around the contacts and above the gate dielectric layer 110 in the example HFET of Fig 1. The passivation layer 105 provides stability of the electrical characteristics of the device by isolating the surface of the device from electrical and chemical contaminants in the environment.

In other examples that use different arrangements of passivation layers, the gate dielectric layer 110 is optional. In examples without the gate dielectric layer 110, the gate contact 130forms a Schottky contact to the second active layer 115, and a separate passivation layer insulates the components E₁ 135, E₂ 140, and E_{N} 145 of the charge distribution structure from the second active layer 115. A Schottky contact is a junction between a metal and a semiconductor that conductscurrent between the metal and the semiconductor in only one direction. Transistors without the gate dielectric layer are sometimes called Schottky gate transistors. An example of a construction that uses an optional gate dielectric layer is presented later in this disclosure.

The example HFET depicted in Fig. 1 is also known as a high electron mobility transistor (HEMT). In the HEMT of Fig. 1, the second active layer 115, which generally has a higher bandgap than the first active layer 120, gives rise to a layer of electric charge 155 in the first active layer 120 near the second active layer 115.The layer of electric charge 155 defines a lateral conductive channel.The first active layer 120 is sometimes called the channel layer. The second active layer 115 is sometimes called the barrier layer or the donor layer. The layer of electric charge 155 which defines the lateral conductive channel is sometimes called a two-dimensional electron gas (2DEG)because electrons, trapped in the quantum well that results from the difference in the bandgaps, are free to move in two dimensions but are tightly confined in the third dimension.As discussed below, the two-dimensional electron gas is thought to arise at least in part from the presence of polarization charge in the second active layer 115. The illustrations and explanations that follow will distinguish polarization charge, surface charge, and the mobile charge of the 2DEG in the HEMT.

When used as a power switch, source contact 125, gate contact 130, and drain contact 150 of the HFET are coupled through terminals to form electrical connections to external circuits. In operation, electric charge in the two-dimensional electron gas 155 moves in a channel between the source contact 125 and the drain contact 150 to become a current in an external circuit. The electric charge, and hence the current, is controlled by a voltage from an external circuit that is electrically connected between the gate contact 130 and the source contact 125.

As used in this disclosure, an electrical connection is an ohmic connection. An ohmic connection is one in which the relationship between the voltage and the current is linear and symmetric for both directions of the current. For example, two metal patterns that contact each through only metal are electrically connected. In contrast, the drain contact 150 and the source contact 125 are not electrically connected in the example HFET of Fig. 1 because any connection between these contacts is through a channel in the semiconductor and controlled by the gate contact 130. Similarly, the gate contact130 is not electrically connected to the semiconductor 115 under the gate contact130, and the gate contact 130 is not electrically connected to the 2DEG 155when a gate dielectric 110 is used to insulate the gate contact 130 from the semiconductor 115 beneath.

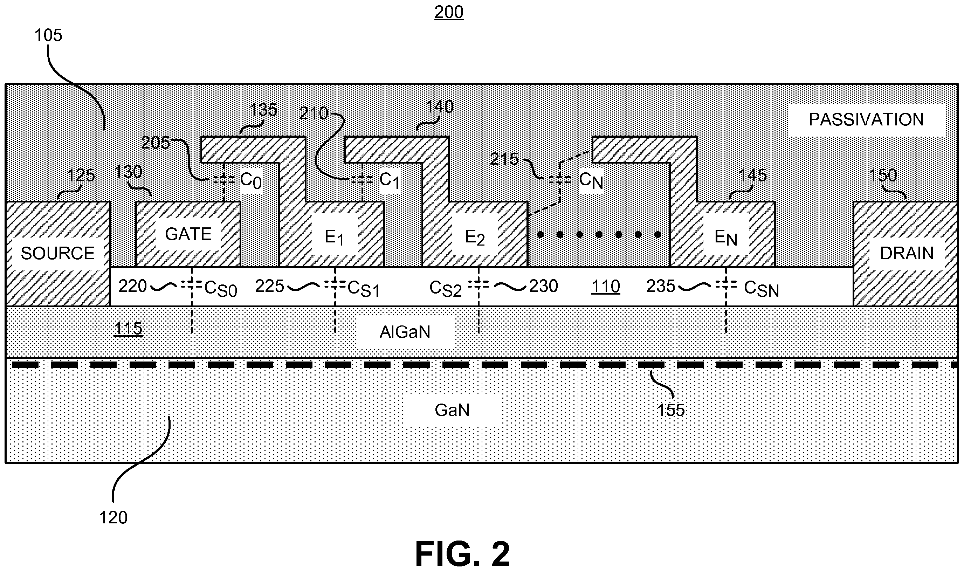

Fig. 2 is a cross-sectional view 200 of the example HFET illustrated in Fig. 1 showing capacitors with dashed lines to represent capacitance between the individual components of the charge distribution structure and between thosecomponents and other parts of the device. It is appreciated that capacitance exists between every pair of objects that can possess an electric charge. Fig. 2 highlights the capacitance that is chiefly involved in the operation of the HFET with the charge distribution structure according to the teachings of the present invention.

Capacitance Co 205 represents the capacitive coupling between the gate contact 130 and component E₁ 135. Capacitance Ci 210 represents the capacitive coupling between component E₁ 135 and component E₂ 140. Capacitance C_{N} 215 represents the capacitive coupling between component E₂140 and component E_{N} 145.

Capacitance Cso 220 represents the capacitive coupling between the gate contact 130 and the 2DEG 155. Similarly, capacitances Csi 225, C_{S2} 230, and C_{SN} 235 represent the capacitive coupling between the 2DEG 155 and components E₁ 135, E₂ 140, E_{N} 145respectively of the charge distribution structure.

Since the components of the charge distribution structure are coupled to other parts of the device by capacitance rather than by direct electrical connection, the individual components of the charge distribution structure can change their electrostatic potentials in response to changes in the voltages applied to the terminals of the device. Since the electrostatic potential of each component of the charge distribution structure may have a different value, the electrostatic potential along the 2DEG 155 can be distributed relatively evenly to avoid undesirable effects of field crowding such as reduced breakdown voltage.

By redistributing electric charge in the presence of changing electric fields, each component of the capacitively-coupled charge distribution structure can match its potential with that of the portion of the conductive 2DEG channel beneath it. This property distinguishes the capacitively-coupled charge distribution structure from conventional conductive field redistribution structures known as field plates that have the electrostatic potential firmly fixed at the potential of one of the device's terminals. Such field plates may formundesirable high magnitude electric fields near their edges.

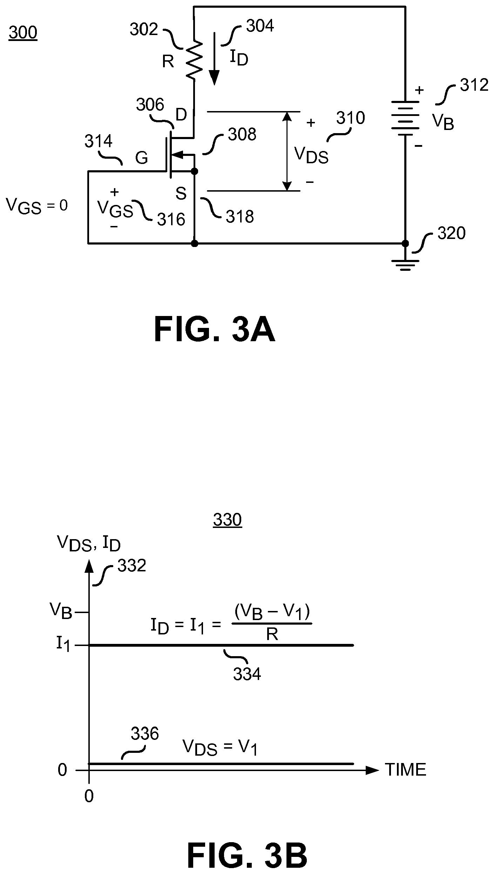

Fig. 3A is a schematic diagram 300 of an example circuit that includes a semiconductor device 308 with a charge distribution structure under the conditions of constant voltage and current. The semiconductor device 308 in Fig. 3A is an HFET switch with a drain terminal 306, a gate terminal 314, and a source terminal 318. Gate terminal 314 and source terminal 318 of HFET 308in the example of Fig. 3A are electrically connected to a common return 320 such that the voltage V_{GS} 316 between the gate 314 and the source 318 is zero.

The drain terminal 306 of HFET 308 in the example of Fig. 3A is coupled to one end of a resistor 302 that has a value R. The other end of resistor 302 is coupled to a terminal of aconstant voltage source 312 that has a positive voltage of value V_{B} with respect to the common return 320. Under the static conditions of the circuit in Fig. 3A, HFET 308 is in the on state, conducting a drain current I_{D} 304 with voltage V_{DS} 310 between the drain terminal 306 and the source terminal 318.

The example semiconductor device 308 is known as a depletion mode device because it requires a non-zero voltage on the gate terminal 314 with respect to the source terminal 318 to stop conduction of drain current I_{D} 304. The normal state of a transistor is generally considered to be a state with no signal between the gate and the source. That is, a depletion mode device is considered to be normally on because it may conduct current when it has zero volts between gate and source. Depletion mode HFET devices require a negative voltage that is more negative than a threshold value between gate and source to stop conduction of drain current I_{D} 304. A positive voltage between gate and source as well as zero voltage between gate and sourcewill allow a depletion mode device to conduct. Conventional HFET devices are depletion mode devices.

Those skilled in the art will appreciate that the present invention may be applied to enhancement mode devices as well as to depletion mode devices. An enhancement mode device requires a non-zero voltage on the gate terminal 314 with respect to the source terminal 318 to allow conduction of drain current I_{D} 304. That is, an enhancement mode device is considered to be normally off because it cannot conduct current when it has zero volts between gate and source. A negative voltage between gate and source will also keep an enhancement mode device off. The examples given in this disclosure with depletion mode devices may be applied to enhancement mode devices by altering the voltage between the gate and the source so that the gate is positive with respect to the source in the on state, and the gate is either negative or at the same potential as the source in the off state.Enhancement mode HFET devices require a positive voltage that is greater than a threshold value between gate and source to allow conduction drain current I_{D} 304.

Fig. 3B is a graph 330 showing the drain current I_{D} 304 and voltage V_{DS} 310 for the example circuit of Fig. 3A on the same vertical axis 332. The graph in Fig. 3B shows that the voltage V_{DS} 310 is a constant value V₁ 336 that is much less than V_{B}, and that the current I_{D} 304 is a constant value I₁ 334 that is the voltageacross the resistor 302 divided by the resistance R. That is, I₁ = (V_{B} - V₁)/R.

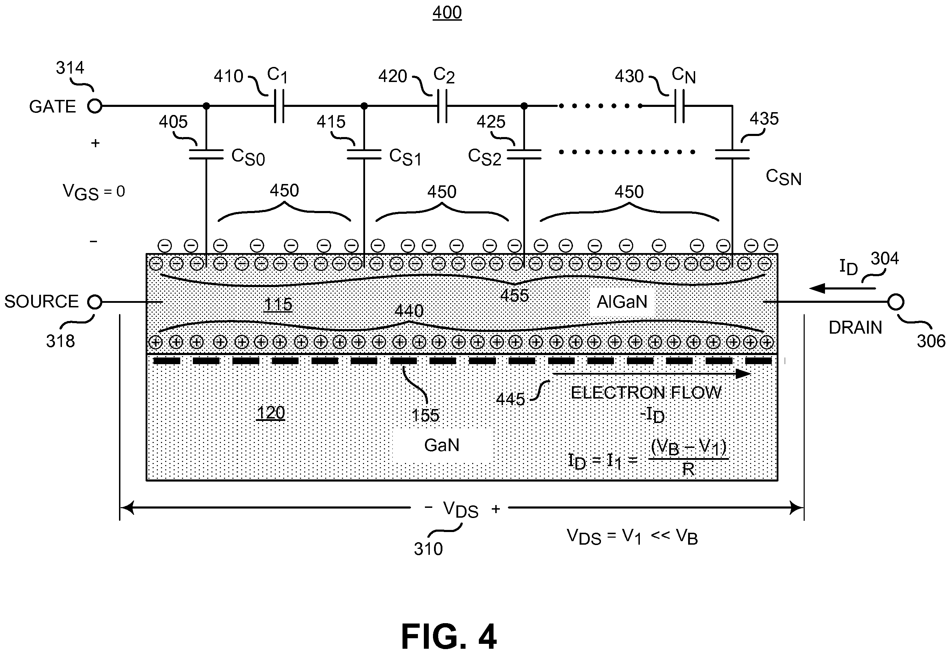

Fig. 4 is a diagram 400 that shows a cross-section of a portion of the example HFET switch 308 in the example circuit of Fig. 3A generally illustrating the distribution of charge and capacitance for the conditions depicted in the graph of Fig. 3B. The mechanical representations of the conductive contacts have been omitted from Fig. 4 to allow betterillustration of the electrical properties of the device.

In the diagram of Fig. 4, capacitors Ci 410, C₂ 420, and C_{N} 430 represent the capacitance between the conductive components of the charge distribution structure as shown in Fig. 2. Similarly, capacitors C_{S1} 415, C_{S2} 425, and C_{SN} 435 in Fig. 4 represent the capacitance between the 2DEG 155 and the components of the charge distribution structure as shown in Fig. 2. Capacitor Cso 405 in Fig. 4 represents a portion of the capacitance between the gate contact 130 and the 2DEG 155 as shown in Fig. 2.

The operation of a HEMT involves interactions between electric charges that arise from multiple physical processes at multiple locations. This disclosure addresses only the charges that are essential to the understanding of the invention, with emphasis on the charges associated with the conduction of current in the capacitance between the conductive components of the charge distribution structure.All known charges are notshown explicitly in the diagrams to avoid unnecessary complexity. It is understood that within the entirety of the device there is an equality of positive and negative charges to make the device electrically neutral. In other words, a negative charge must be compensated by a positive charge somewhere in the device.

Fig. 4 shows examples of polarization charge, free mobile charge, and surface charge.Polarization charges 440 and 455are examples of immobile charge within the second active layer 115. Positive polarization charge 440 near the boundary between the second active layer 115 and the first active layer 120 is compensated by negative polarization charge455 below the upper surface of the second active layer 115. The origin of the polarization charge will be explained later in this disclosure. The 2DEG 155 in the first active layer 120 is an example of free mobile chargethat is negative because electrons carry a negative charge. Other mobile negative charges 450 that are also electrons are removed from the surface of the second active layer 115 to form a positive surface charge (not shown explicitly in Fig. 4) that compensates the negative charge of the 2DEG 155.

Fig. 4 shows an electron flow 445 that is the result of the drain current I_{D} 304. The electrons comprising the 2DEG 155 move between the source terminal 318 and the drain terminal 306 when the switch 308 is conducting. The electron current 445 is in the opposite direction from the external drain current 304 because electrical current in a circuit is defined by convention to be the flow of positive charge, whereas the electrons have a negative charge. Thus, for electric current, movement of positive charge in one direction is equivalent to movement of negative charge in the opposite direction.

The behavior of an HFET may be understood from the interactions between electric fields and electric charges. An electrically neutral device has no net charge. In other words, every positive charge in an electrically neutral device has a corresponding negative charge so that the sum of the positive and negative charges is zero. Although the device may be electrically neutral, the positive and negative charges may not be uniformly distributed within the device. Electrical neutrality does not imply the absence of electric fields. The distribution of charges and the resulting electric fields are important because they influence the breakdown capability of the device.

In an electrically neutral HFET, mechanical forces that originate from the mismatch between the spacing between atoms in the different materials produce an electric field, sometimes called a piezoelectric field, which extends from the substrate to the surface of the device. The internal piezoelectric field acts on ionized donor atoms and polarization charges (bound charges rearranged into dipoles) to form a positive charge 440in the second active layer 115 at the junction between the first active layer 120 and the second active layer 115. The electric field from the positive charges 440 attracts the negative charges of the electrons in the channelto the junction. In other words, the positive charge 440 is locally compensated by the negative charge from the two dimensional electron gas 155 that is necessary for the drain current I_{D} 304.

To the extent that the positive charge 440 is due to polarization charge, which with the negative polarization charge 455 has a sum total charge of zero, the free electrons in the channel are globally uncompensated by the polarization charge. Since the layers in the HFET switch 308 are commonly undoped or doped only slightly (unintentionally), the electrons in the channel must be compensated in some other way. The compensation charge has been found to reside on the surface of the HFET switch 308. As shown in Fig. 4, negative charges450 may be transferred between the surface of the HFET switch 308 and the ambient environment to leave a compensating positive charge (not explicitly shown) at the surface of the HFET switch 308. Without this compensation charge, the channel of the device would not be conducting.

Under dynamic conditions when the HFET switch 308 is changing from the on state to the off state, electrons in the two dimensional electron gas leave the channel between the source and the drain. Moreover, the charge in the channel may not be uniformly distributed between drain and source under dynamic conditions. If the positive compensation charge at the surface of HFET switch 308 remains fixed while the negative charge in the channel reduces, electric field gradients (the amount the electric field changes over a distance) may get high enough to damage the device. One purpose of the charge distribution structure is to facilitate charge transfer on the surface of the device to compensate the changing charge in the channel such that the electric field is spread more or less uniformly in the semiconductor material between the source and the drain.

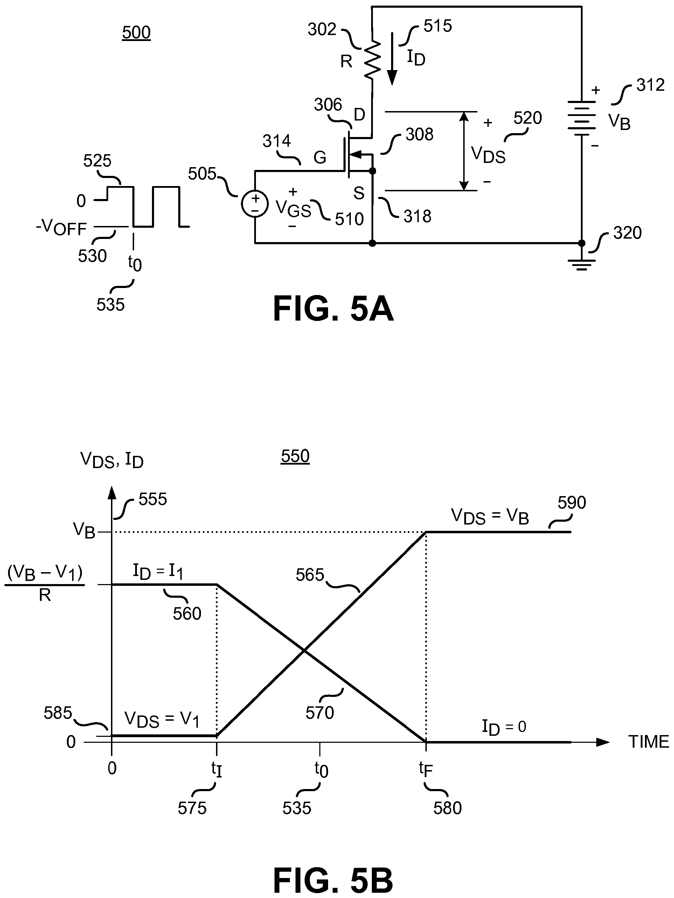

Fig. 5A is a schematic diagram 500 that shows the example circuit of Fig. 3A modified for dynamic operation. A variable voltage source 505 is coupled between the gate terminal 314 and the source terminal 318 of HFET 308 in the example of Fig. 5A. Variable voltage source 505 changes the voltage V_{GS} 510 between a negative value -V_{OFF} 530 and a relatively smallpositive value 525. In the example of Fig. 5A, HFET 308 is in an on state when the voltage V_{GS} 510 is ata value 525greater than or equal to zero, and HFET 308 is in an off state when the voltage V_{GS} 510 is at a negative value -V_{OFF} 530 that is more negative than a threshold value. Once again, this discussed polarity corresponds to one example HFET which is normally on (depletion mode). For a normally off HFET (enhancement mode), the device would be in an off state when the voltage V_{GS} 510 is less than or equal to a positive threshold value, and in an on state when the voltage V_{GS} 510 is greater than the positive threshold value. In the example of Fig. 5A, HFET 308 switches from an on state to an off state at time to 535.

Fig. 5B is a graph 550 that shows the drain current I_{D}515 and voltage V_{DS}520 of the example HFET switch 308 in the example circuit of Fig. 5A with respect to time in the vicinity of to535. Current and voltage are plotted in Fig. 5B on the same vertical axis 555. The graph 550 shows that the transition between the on state and the off state takes place over a finite interval between an initial time t_{I} 575 and a final time t_{F} 580.

During the transition, the drain current 570 changes from a value I₁ 560 before time t_{I} 575 to substantially zero after time t_{F} 580. Also during the transition, the voltage 565 between the drain terminal 306 and the source terminal 318 changes from a value Vi 585 before time t_{I} 575 to a much higher value V_{B} 590 after time t_{F} 580.

It is appreciated that practical circuits have inductance that is not considered in the example circuit of Fig. 5A. If typical values of inductance were taken into account, the transition of drain current from the value Ii 560 to substantially zerobetween time t_{I} 575 and time t_{F} 580 would raise the voltage between the drain terminal 306 and the source terminal 318 to a value substantially higher than the value V_{B} of the voltage source 312. Thus, the breakdown voltage of a power switch typically must be much greater than the highest power supply voltage in the circuit.

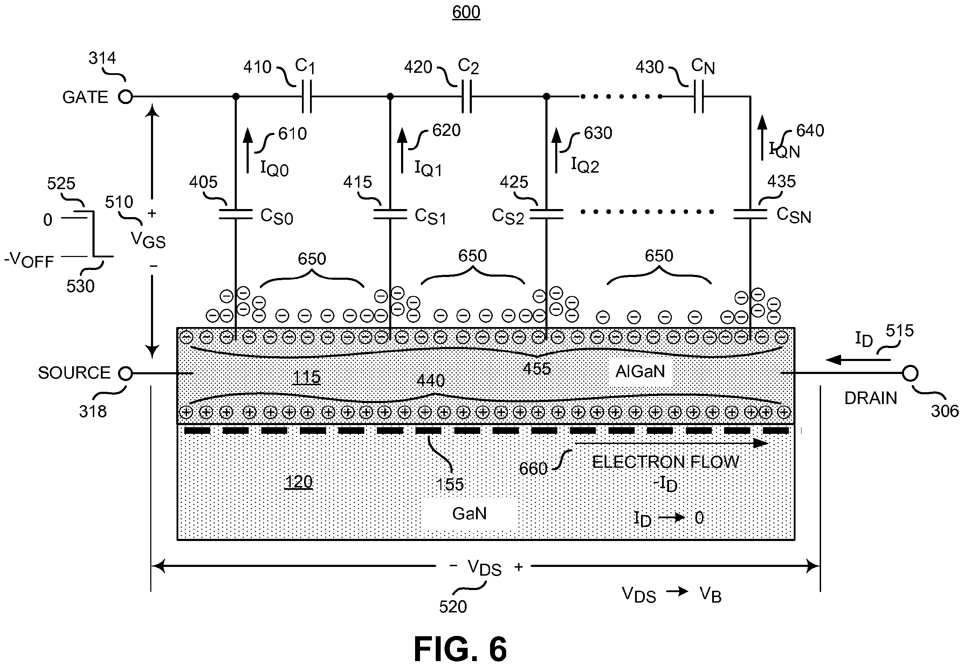

Fig. 6 is a diagram 600 that shows the same cross-section as Fig. 4 under the dynamic conditions of the example circuit of Fig. 5A, generally illustrating the distribution of charge and currents for the conditions depicted in the graph of Fig. 5B. As in Fig. 4, the mechanical representations of the conductive contacts have been omitted to allow better illustration of the electrical properties of the device.

Fig. 6 shows the operation of the example capacitively-coupled charge distribution structure during the transition from the on state to the off state as illustrated in Fig. 5B between time t_{I} 575 and time t_{F} 580. As illustrated in Fig. 6, electron flow 660 and drain current I_{D} 515 are decreasing toward zero as the voltage V_{DS} 520 between the drain terminal 306 and the source terminal 318 is increasing toward the value V_{B}.

Electrons leave the two dimensional electrongas of the channel as the electron flow 660 decreases toward zero, making the charge in the channel less negative. As a consequence, the positive surface charge, which compensates for the electron gas of the channel, needs to be reduced. A reduction in positive charge at the surface is achieved by an increase in negative charge 650 at the surface. Accordingly, capacitors Cso 405, Csi 415, C_{S2} 425, and C_{SN}435 conduct currents I_{Q0} 610, I_{Q1} 620, I_{Q2} 630, and I_{QN} 640, respectively,as electrons from the ambient environment accumulate to reduce the positive surface charge of the second active layer 115. A reduction in charge is sometimes referred to as a discharge. A restoration in charge is sometimes referred to as a recharge. The dynamic distribution of charge at the surface of second active layer 115 spreads the electric field in the material between the drain terminal 306 and the source terminal 318 more or less uniformly as the power switch makes the transition from the on state to the off state. Therefore, the charge distribution structure is configured to produce a surface discharge and a surface recharge on the HFET device during a switching transition of the device.

Similarly, as the HFET switch makes the transition from the off state to the on state, electrons enter the two dimensional electron gas of the channel as the electron flow 660 increases.As a consequence, the positive surface charge needs to increase in order to compensate for the increase in the electron gas of the channel. Accordingly, capacitors Cso 405, Csi 415, C_{S2} 425, and C_{SN} 435 conduct currents that transfer electrons from the surface of the HFET to the ambient environment, increasing the positive charge at the surface of the second active layer 115.

As previously mentioned, it is often desirable to make the transition between the off state and the on state as fast as possible. The speed of this transition is referred to as the switching speed of the device. If a signal were to drive the HFET at a rate faster than its switching speed, the device may experience premature breakdown, which can lead to irreversible device degradation. An important factor in determining the switching speed of the device is its surface discharge and recharge times, which will depend in part on the particular configuration that is used for the charge distribution structure. Accordingly, the charge distribution structure generally should be designed so that it produces a surface discharge and recharge at a rate that is greater than a design target switching speed.

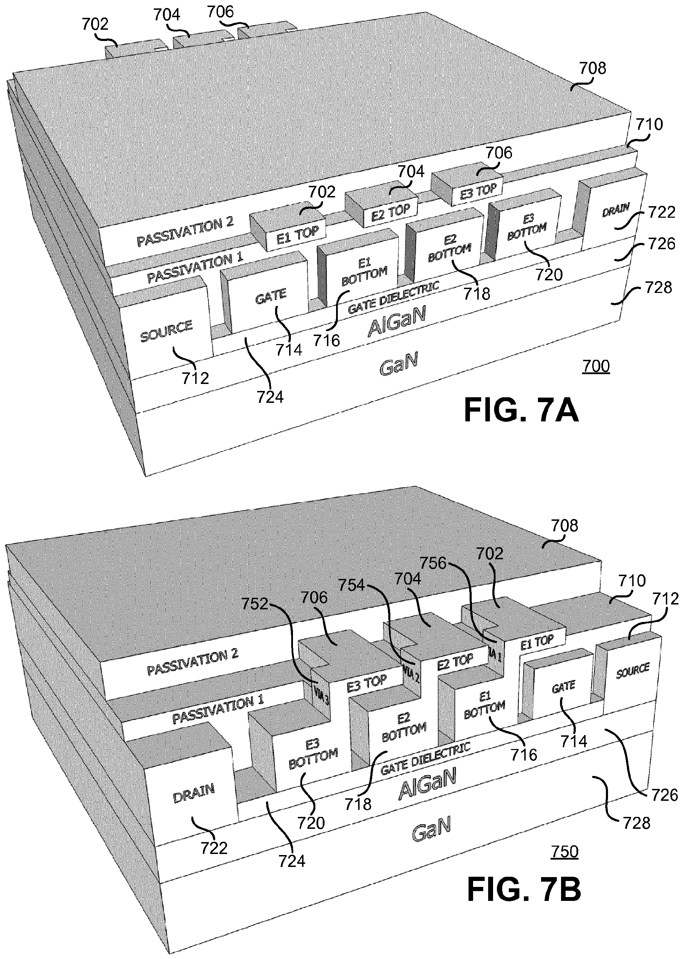

Fig. 7A is a perspective view 700showingthe relative positions of various parts and features of an example HFET including a capacitively-coupled charge distribution structure. Fig. 7B is a different perspective view750 of the device shown in Fig. 7A. The example semiconductor device shown in Fig. 7A and Fig. 7B issame type of device described in Fig. 1.

Fig. 7A and Fig. 7B illustrate how components of a charge distribution structure may be assembled from metal deposited during the fabrication of an HFET. Portions of some layers of the example device have been removed in Fig. 7A and Fig. 7B to expose underlying features in greater detail. All layers would normally cover the entire device, ending at the same vertical plane on each side of the device.

Consistent with the cross-section representation of Fig. 1, the face nearest the observer in the perspective view of Fig. 7A shows a first active layer 728, a second active layer 726, and a dielectric layer 724. Fig. 7A also shows a conductive source contact 712 and a conductive drain contact 722 deposited over the second active layer 726.

The gate dielectric 724 is deposited over the second active layer 726 between the source contact 712 and the drain contact 722. A conductive gate contact 714 is deposited over the gate dielectric layer 724. Fig. 7A and Fig. 7B show the passivation layer 105 illustrated in Fig. 1 as two layers of passivation, 708 and 710, to indicate that the passivation is deposited in two steps of the fabrication process.

A feature not apparent in the cross-section of Fig. 1 but shown clearly in Fig. 7A and Fig. 7B is that the example charge distribution structure is fabricatedon two different layers. Horizontal components of the charge distribution structure are fabricated from conductive material of appropriate thickness, appearing as stripes in a conventional two-dimensional view from the top. In one example, the thickness of the stripes may be approximately the same dimension as the width of the stripes. While the examples discussed herein refer to the horizontal components as stripes, more generally the horizontal components may be elongate members having a wide variety of different cross-sectional shapes.

Fig. 7A shows top stripes 702, 704, and 706, which form one layer, and bottom stripes 716, 718, and 720, which form another layer of three conductive components of a charge distribution structure. For example, the conductive componentE1 is constructed from two stripes 702 and 716 of conductive material.Likewise, the conductive component E2 is constructed from two stripes 704 and 718 of conductive material and the conductive component E3 is constructed from two stripes 706 and 720 of conductive material. As shown, the top stripe of one component of the charge distribution structure overlaps at least in part with the bottom stripe of an adjacent conductive component so that they are capacitively coupled to one another. For instance, top stripe 704 of component E2 overlaps with bottom stripe 716 of component E1 and top stripe 706 of component E3 overlaps with bottom stripe 718 of component E2. In addition, top stripe 702 of conductive component E1 overlaps with gate 714.

The top conductive stripe and the bottom conductive stripe of each conductive component may be separated along most of their lengths by an insulating passivation layer, and joined togetheronly along a relatively small section of their respective lengths through a via in the insulating passivation layer.

Fig. 7B shows top stripe 702 joined to bottom stripe 716, top stripe 704 joined to bottom stripe 718, and top stripe 706 joined to bottom stripe 720 by respective conductive depositions 756, 754, and 752 through vertical vias in passivation layer 710 at one end of each stripe.

It is appreciated that a top stripe and a bottom stripe of a component of a charge distribution structure may be joined at any place between the ends of the stripes. They may be joined either within the active area of the semiconductor device or outside the active area of the semiconductor device.

The dimensions of the stripes and the distance between them may be chosen along with the electrical properties of the dielectric material to achieve a desired capacitance between the components of the charge distribution structure. For example, the spacing between the gate contact 714 and the drain contact 722 will be set by the magnitude of the electrical field deemed appropriate for the application, typically between 50 and 100 volts per micron for a GaN device. The lithographic technology selected for fabrication of the device will determine the minimum width of the stripes. Knowledge of the minimum width and the desired electric field allows the designer to compute the number of stripes and the spacing between them. The maximum number of stripes may be determined from the minimum width and the distance between the stripes necessary to achieve the desired magnitude of electrical field between the stripes. Using the assumption that the 2DEG under each stripe will be depleted when the device is off, the designer can compute an amount of charge associated with each stripe. The capacitance between each bottom stripe and the channel beneath it can be computed from the voltage and the charge. The capacitance between the top stripe and the adjacent bottom stripe must be sufficiently greater than the capacitance between the bottom stripe and the channel to guarantee that the charge associated with the channel can be transferred between components of the charge distribution structure.

As discussed above, in one embodiment, the charge distribution structure generally should be designed so that it produces a surface discharge and recharge at a rate that is greater than a design target switching speed. The amount of discharge and recharge that is needed to achieve satisfactory results may be application-dependent. However, in general, the amount charge that is to be provided during the recharge process should be comparable to the space-charge that is present in the channel. In one particular embodiment the amount of discharge may be at least about 90% of the maximum surface charge that accumulates below the stripes of the charge distribution structure. Likewise, the amount of recharge may be at least about 90% of the maximum surface charge that accumulates below the stripes of the charge distribution structure.The amount of recharge is expected to be substantially equal to the amount of discharge during a switching cycle so that at the end of the switching cycle the device is returned to its state at the beginning of the switching cycle. Of course, the amount of discharge and recharge will be less at locations that are not directly below the stripes of the charge distribution structure.In order to compensate for surface charge that is depleted between stripes, in some embodiments the recharge may be greater than 100% of the maximum charge that accumulates below the stripes. In this way, charge can be distributed to those surface portions between the stripes.

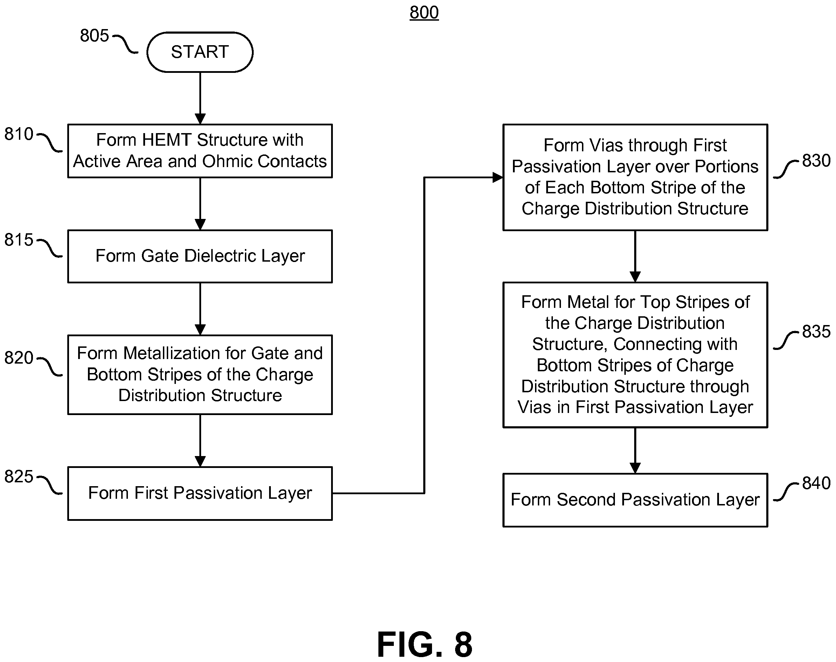

Fig. 8 is an example flow diagram illustrating generally a sample flow of operations in an example process to construct the example semiconductor device illustrated in Fig. 7A and Fig. 7B with a charge distribution structure in accordance with the teachings of the present invention. After starting in block 805, a structure for a high electron mobility transistor (HEMT) is formed in block 810 with an active area and ohmic contacts for the drain and the source as is known in the art. A gate dielectric layer is then formed over the active area in step 815.

After the gate dielectric layer is formed in block 815, metallization for the gate and metallization for the bottom stripes of a charge distribution structure are formed over the gate dielectric layer in block 820. Next, in block 825, a first passivation layer is formed over the metal for the gate, the metal for the bottom stripes, and the contacts for the drain and source.

Vias are then formed through the first passivation layer in block 830 where it is desired to join the bottom stripes with top stripes to form components of the charge distribution structure. Metal is then deposited in block 835on the surface of the first passivation structure and through the vias in the first passivation layer to form top stripes of the charge distribution structure that are joined to bottom stripes of the charge distribution structure. The process ends with the formation of a second passivation layer in block 840.

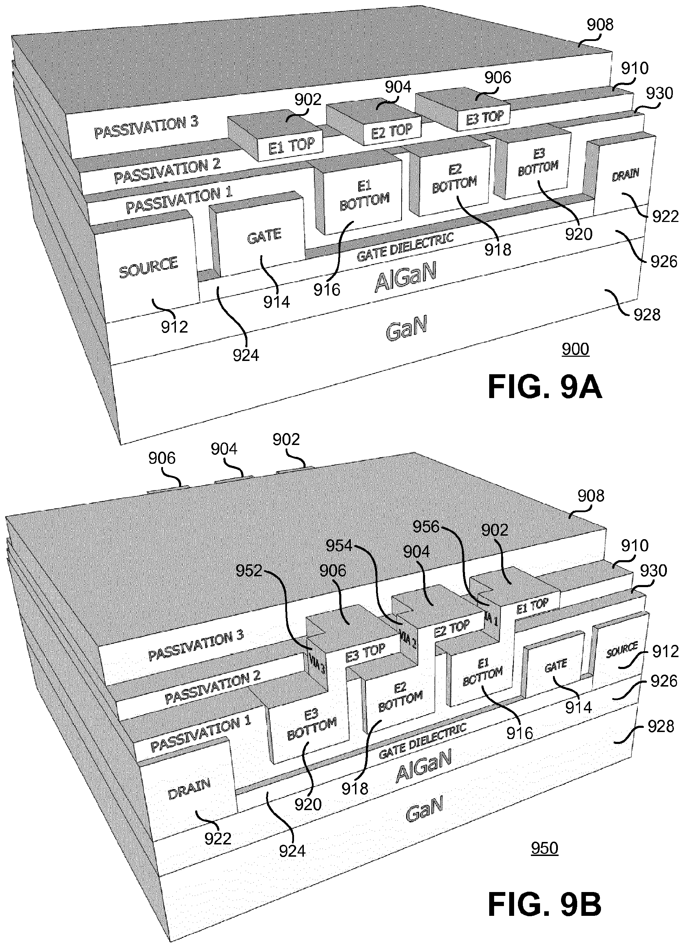

Fig. 9A is a perspective view 900 showing the relative positions of various parts and features of another example HFET including a capacitively-coupled charge distribution structure. Fig. 9B is a different perspective view 950 of the device shown in Fig. 9A. The example semiconductor device shown in Fig. 9A and Fig. 9B has an additional layer of passivation that allows an optional gate dielectric layer, whereas the gate dielectric layer 724 is mandatory in the structure illustrated in Fig. 7A and Fig. 7B. In examples without the gate dielectric layer 924, the gate contact 914 forms a Schottky contact to the second active layer 926, and the passivation layer 930 insulates the components E₁ 916, E₂ 918, and E₃ 920 of the charge distribution structure from the second active layer 926.

Fig. 9A and Fig. 9B illustrate how components of a charge distribution structure may be assembled from metal deposited during the fabrication of an HFET. As in Fig. 7A and Fig. 7B, portions of some layers of the example device have been removed in Fig. 9A and Fig. 9B to expose underlying features in greater detail.

Similar to the views of Fig. 7A and Fig. 7B, the face nearest the observer in the perspective view of Fig. 9A shows a first active layer 928, a second active layer 926, and an optional dielectric layer 924. Fig. 9A also shows a conductive source contact 912 and a conductive drain contact 922 deposited over the second active layer 926.

The optional gate dielectric 924 is deposited over the second active layer 926 between the source contact 912 and the drain contact 922. A conductive gate contact 914 is deposited over the gate dielectric layer 924, followed by a first passivation layer 930 deposited over the gate contact 914, source contact 912, and drain contact 922. In examples that do not use the gate dielectric 924, gate contact 914 is deposited directly on the second active layer 926 to form a Schottky contact.

The first passivation layer 930 surrounds three sides of bottom stripes 916, 918, and 920 of the capacitively-coupled charge distribution structure, separating the bottom stripes from each other and from other parts of the device below and adjacent to the bottom stripes. Fig. 9A and Fig. 9B also show a second passivation layer 910 and a third passivation layer908.

Similar to Fig. 7A and Fig. 7B, the alternative construction of Fig. 9A shows top stripes 902, 904, and 906 with bottom stripes 916, 918, and 920 that form three components of a charge distribution structure. Fig. 9B shows top stripe902 joined to bottom stripe916, top stripe904 joined to bottom stripe918, and top stripe906 joined to bottom beam 920 by respective conductive depositions 956, 954, and 952 through vertical vias in passivation layer 910 at one end of each stripe.

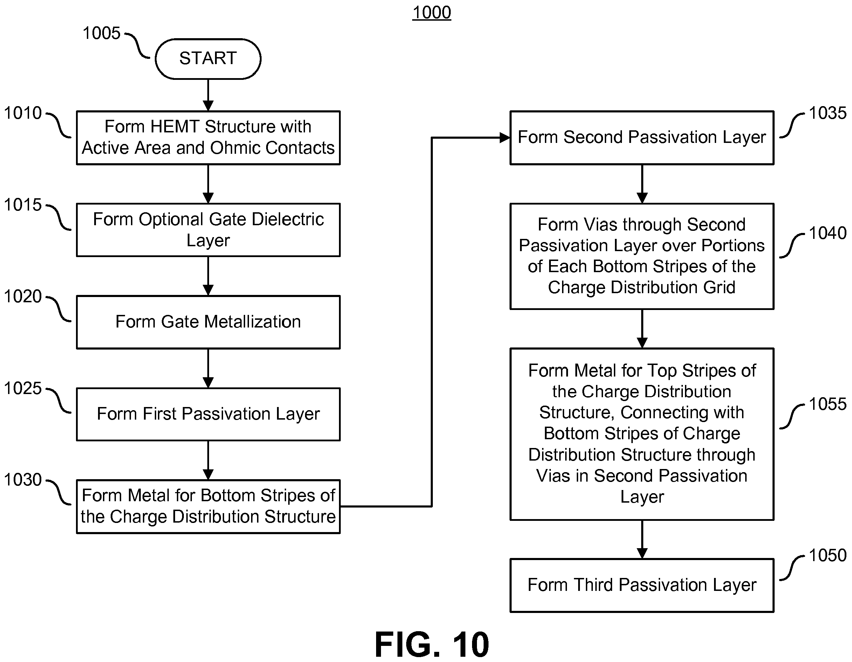

Fig. 10 is an example flow diagram illustrating generally a sample flow of operations in an example process to construct the example semiconductor device illustrated in Fig. 9A and Fig. 9B with a charge distribution structure. After starting in block 1005, a structure for a high electron mobility transistor (HEMT) is formed in block 1010 with active area and ohmic contacts for the drain and the source as is known in the art. An optional gate dielectric layer may then be formed over the active area in block 1015. Block 1015 is skipped in examples that do not use the optional gate dielectric layer.

After the completion of the operation in block 1015 in examples that use the optional gate dielectric layer, metallization for the gate is then formed in block 1020. Next, a first passivation layer is formed over the metal for the gate and the contacts for the drain and source in block 1025. The formation of the first passivation layer may include removal of passivation material to form channels for the bottom stripes of the charge distribution structure. Then in block 1030 metal is deposited for the bottom stripes of the charge distribution structure, followed by a second passivation layer in block 1035.

Vias are then formed through the second passivation layer in block1040 where it is desired to join the bottom stripes with top stripes to form components of the charge distribution structure. Metal is then deposited in block1055on the surface of the second passivation layer and through the vias in the second passivation layer to form top stripes of the charge distribution structure that are joined to bottom stripes of the charge distribution structure. The process ends with the formation of a third passivation layer in block1050.

High voltage HFETs are fabricated to have, among other properties, a breakdown voltage that is predictable and stable. The fabrication of high voltage HFETs may include special structures of conductive components surrounded by an electrically insulating material. Such insulated conductors are sometimes called floating conductors because their electric potentials do not have a well-controlled relationship to a reference electric potential value under static conditions. The floating conductors may change their potentials in a controlled way under dynamic conditions.

Examples of such special structures include the charge distribution structures of the high voltage HFETs shown in Figs. 1, 2, 3A, 4, 5A, 6, 7A, 7B, and 9A, 9B, Capacitive coupling between the conductive components within the electrically insulating material may allow the net total electric charges to distribute more or less uniformly within a region of the device in response to rapid changes in voltage at the terminals of the device. The distribution of charge during voltage transitions may prevent high local electric fields that can reduce the breakdown voltage. Use of charge distribution structures may also allow designers of the device to make accurate predictions of breakdown voltage before fabrication.

A perfect insulating material surrounding the conductive components of the charge distribution structure would prevent the conductive components from acquiring a static charge from the environment. Electric currents leaking through an imperfect insulating material could cause charge to accumulate on the conductive components of the charge distribution structure.

Electric fields from accumulated static charge can interfere with the ability of the charge distribution structure to prevent the high dynamic electric fields that reduce the breakdown voltage of the device. Since the accumulated static charge is the result of past electrical stress on the device, the breakdown voltage may depend on the device's history.

In some circumstances, it may be necessary to prevent the accumulation of static electric charge on floating conductors in semiconductor devices.

For example, a network of transistors that is coupled to the conductors in a charge distribution structure of a semiconductor device can be used. The transistors of the network allow electric charge to accumulate on the conductors when the semiconductor device is in an off state, and the transistors automatically reduce the accumulated charge on the conductors when the semiconductor is in an on state.

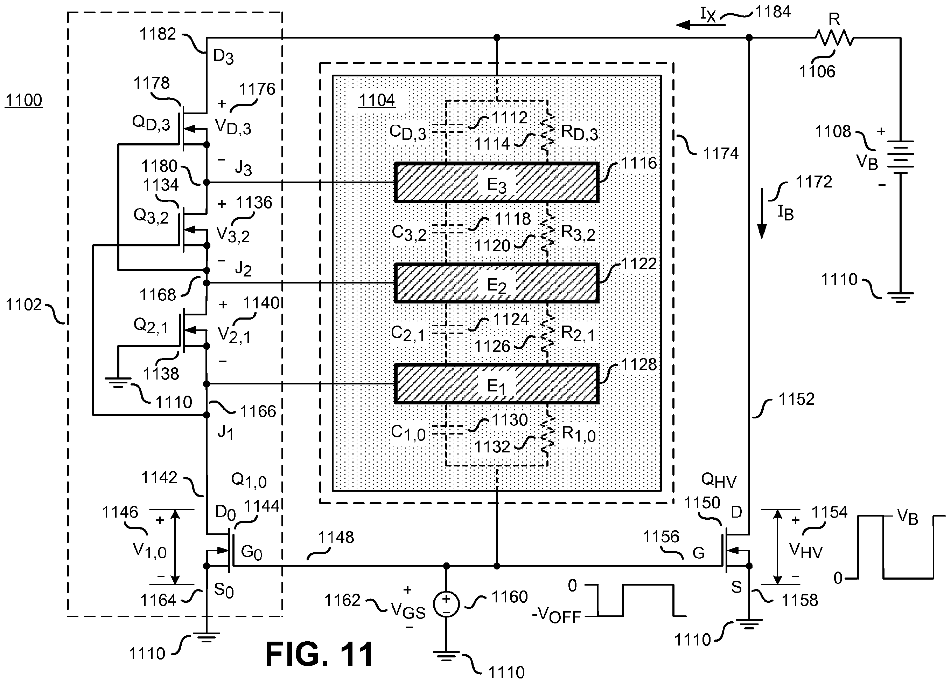

Fig. 11 is electrical schematic diagram 1100 that shows an equivalent circuit of an example static discharge system 1102. In the circuit of Fig. 11, transistor Q_{HV} 1150 is a high voltage HFET that includes components of an internal capacitively-coupled charge distribution structure 1174. Transistor Q_{HV} 1150 is an HFET with a drain terminal 1152, a gate terminal 1156, and a source terminal 1158.

The internal capacitively-coupled charge distribution structure 1174 of high voltage HFET Q_{HV} 1150 is represented by conductive components E₁ 1128, E₂ 1122, and E₃ 1116 that are surrounded by an electrically insulating material 1104. An example physical construction of an example high voltage HFET that includes a charge distribution structure is presented later in this disclosure.

Fig. 11 shows capacitors with dashed lines within the electrically insulating material 1104 to represent capacitance between the individual components of the charge distribution structure 1174 and between those components and other parts of the transistor Q_{HV} 1150. It is appreciated that capacitance exists between every pair of objects that can possess an electric charge. The representation in Fig. 11 highlights the capacitance that is discharged by the static discharge system 1102.

Capacitance C_{D,3} 1112 represents the capacitive coupling between the drain terminal 1152 of transistor Q_{HV} 1150 and component E₃ 1116. Capacitance C_{3,2} 1118 represents the capacitive coupling between component E₃ 1116 and component E₂ 1122. Capacitance C_{2,1} 1124 represents the capacitive coupling between component E₂ 1122 and component E₁ 1128. Capacitance Ci,o represents the capacitive coupling between component E₁ and the gate terminal 1156 of transistor Q_{HV} 1150.

Fig. 11 also shows resistors with dashed lines within the insulating material 1104 to represent the finite resistance that exists between the individual components of the charge distribution structure 1174 and between those components and other parts of the transistor Q_{HV} 1150. Since electrical insulating material 1104 is imperfect, electric charge is able to move within the material in response to electric fields that correspond to difference in voltage. The movement of charge between conductors within the insulating material in response to a difference in voltage between conductors is sometimes referred to as leakage current.

Resistor R_{D,3} 1114 represents the resistance between the drain terminal 1152 of transistor Q_{HV} 1150 and component E₃ 1116 of the charge distribution structure 1174. Resistor R_{3,2} 1120 represents the resistance between component E₃ 1116 and component E₂ 1122 of the charge distribution structure 1174. Resistor R_{2,1} 1126 represents the resistance between component E₂ 1122 and component E₁ 1128 of the charge distribution structure 1174. Resistor Ri,o represents the resistance between component E₁ 1128 and the gate terminal 1156 of transistor Q_{HV} 1150. The value of the resistance between conductive components of the charge distribution structure 1174 and the terminals of the transistor Q_{HV} 1150 is determined by the resistivity of the insulating material 1104 and by the physical separation between the conducting components and the terminals.

Transistor Q_{HV} 1150 in the example of Fig. 11 operates as a switch in a circuit that includes a constant voltage source V_{B} 1108 and a resistor R 1106. In typical applications, voltage source V_{B} may have a value of several hundred volts. In the example of Fig. 11, voltage source V_{B} 1106 has a negative terminal coupled to a common return 1110 and a positive terminal coupled to one end of resistor 1106. The other end of resistor 1106 is coupled to the drain terminal 1152 of transistor Q_{HV} 1150. The source terminal 1158 of transistor Q_{HV} 1150 is coupled to the common return 1110. In the example of Fig. 11, a variable voltage source 1160 that produces a switching control voltage V_{GS} 1162 is coupled between the gate terminal 1156 and the common return 1110.

When transistor Q_{HV} 1150 in the example of Fig. 11 is switched on, transistor Q_{HV} 1150 conducts a current I_{B} 1172 through resistor 1106 from constant voltage source 1108, and the voltage V_{HV} 1154 between the drain terminal 1152 and the source terminal 1158 is much less than the voltage of constant voltage source V_{B} 1108. The voltage V_{HV} 1154 between the drain terminal 1152 and the source terminal 1158 is typically less than five volts when transistor Q_{HV} is switched on. When transistor Q_{HV} 1150 is switched off, there is substantially zero current in resistor 1106, and the voltage V_{HV} 1154 between the drain terminal 1152 and the source terminal 1158 is substantially the value of the constant voltage source V_{B} 1108. Therefore, in a typical application the voltage V_{HV} 1154 may switch between a few volts and several hundred volts.

Transistor Q_{HV} 1150 in the example of Fig. 11 is known as a depletion mode device because it requires a non-zero voltage on the gate terminal 1156 with respect to the source terminal 1158 to stop conduction of drain current I_{B} 1172. The normal state of a transistor is generally considered to be a state with no signal between the gate and the source. That is, a depletion mode device is considered to be normally on because it may conduct current when it has zero volts between gate and source. Depletion mode HFET devices require a negative voltage that is more negative than a threshold value between gate and source to stop conduction of drain current I_{B} 1172. A positive voltage between gate and source as well as zero voltage between gate and source will allow a depletion mode device to conduct. In the example of Fig. 11, switching control voltage 1162 switches to a negative value -V_{OFF} that is more negative than the threshold voltage of transistor Q_{HV} 1150 to switch transistor Q_{HV} 1150 off. Conventional HFET devices are depletion mode devices.

When transistor Q_{HV} 1150 is off and voltage V_{HV} 1154 is high, conductive components E₃ 1116, E₂ 1122, and E₁ 1128 of the charge distribution structure 1174 may accumulate a static charge from leakage currents in the electrically insulating material 1104. The magnitude of the static charge that may accumulate without a static discharge system is influenced by the capacitance and the electrical resistance between the individual conductors, as well as by the average voltage that appears between the drain 1152 and the gate 1156 of transistor Q_{HV} 1150. Electric fields that result from the accumulated static charge may reduce the breakdown voltage of transistor Q_{HV} 1150. In the absence of a static discharge system, the accumulated charge may remain in the device for a time that may range from minutes to days. The static discharge system 1102 shown in Fig. 11 may reduce the accumulated charge to negligible levels every time transistor Q_{HV} 1150 turns on.

The circuit of the example static discharge system 1102 in Fig. 11 includes transistors Q_{D,3} 1178, Q_{3,2} 1134, Q_{2,1} 1138, and Q_{1,0} 1144. All transistors in Fig. 11 are depletion mode HFET devices. The transistors in the static discharge system 1102 may have substantially lower breakdown voltages than high voltage transistor Q_{HV} 1150 because resistors R_{D,3} 1114, R_{3,2} 1120, R_{2,1} 1126 and R_{1,0} 1132 form a voltage divider circuit that allows only a fraction of the high voltage V_{HV} 1154 to appear across any transistor in the static discharge system 1102. As such, the transistors in the static discharge system 1102 do not require charge distribution structures. Therefore, the low voltage transistors in the static discharge system 1102 and the high voltage power transistor Q_{HV} 1150 may be fabricated together on the same semiconductor wafer, with only transistor Q_{HV} 1150 having a charge distribution structure.

Fig. 11 shows that the gate G₀ 1148 of transistor Q_{1,0} 1144 in the static discharge system 1102 is coupled directly to the gate G 1156 of high voltage transistor Q_{HV 11}50, and the source So 1164 of transistor Q_{1,0} 1144 is coupled to the source S 1158 of high voltage transistor Q_{HV 11}50 through the common return 1110. Since transistors Q_{1,0} 1144 and Q_{HV} 1150 are both depletion mode HFET devices with approximately the same threshold voltages, both transistors turn on and turn off at the same time.

When transistors Q_{HV} 1150 and Q_{1,0} 1144 in the example of Fig. 11 turn on, all transistors turn on, and the drain-to-source voltages V_{HV} 1154, V_{1,0} 1146, V_{2,1} 1140, V_{3,2} 1136, and V_{D,3} 1176 will be typically less than five volts. Since transistor Q_{HV} 1150 is substantially larger than the transistors in the static discharge structure 1102, transistor Q_{HV} 1150 conducts nearly all the current in resistor R 1106. In other words, current Ix 1184 that goes to the charge distribution structure 1174 and to the static discharge system 1102 is negligible in comparison to the current I_{B} 1172 in transistor Q_{HV} 1150.

The drain terminal Do 1142 of transistor Qi,o 1144 is coupled to conductive component E₁ 1128 of the charge distribution structure 1174. Since voltage V_{HV} 1154 will be typically less than five volts when transistor Q_{1,0} 1144 is on, V_{1,0} will be typically between zero and five volts when transistor Q_{1,0} 1144 is on. Therefore, when transistor Qi,o 1144 turns on, static charge on conductive component E₁ 1128 of the charge distribution structure 1174 is discharged to the common return 1110, and the voltage on the capacitance C_{1,0} 1130 is reduced to typically much less than five volts.

Fig. 11 shows transistor Q_{2,1} 1138 coupled between conductive components E₂ 1122 and E₁ 1128 of the charge distribution structure 1174. The voltage between conductive components E₂ 1122 and E₁ 1128 is the drain-to-source voltage V_{2,1} 1140 of transistor Q_{2,1} 1138. The gate terminal of transistor Q_{2,1} 1138 is coupled to the common return 1110. The source terminal of transistor Q_{2,1} 1138 is coupled to the drain terminal of transistor Q_{1,0} 1144, and to the gate terminal of transistor Q_{3,2} 1134, and to the conductive component E₁ 1128 at a junction J₁ 1166. As used in this disclosure, a junction is an electrical termination that is both a source terminal of a transistor and a drain terminal of a different transistor.

Fig. 11 also shows transistor Q_{3,2} 1134 coupled between conductive components E₃ 1116 and E₂ 1122 of charge distribution structure 1174. The drain terminal of transistor Q_{3,2} 1134 is coupled to conductive component E₃ 1116 of charge distribution structure 1174 and to the source terminal of transistor Q_{D,3} 1178 at a junction J₃ 1180. The source terminal of transistor Q_{3,2} 1134 is coupled to the drain terminal of transistor Q_{2,1} 1138, and to the gate terminal of transistor Q_{D,3} 1178, and to conductive component E₂ 1122 of charge distribution structure 1174 at a junction J₂ 1168. The voltage between conductive components E₃ 1116 and E₂ 1122 of charge distribution structure 1174 is the drain-to-source voltage V_{3,2} 1136 of transistor Q_{3,2} 1134. The gate terminal of transistor Q_{3,2} 1134 is coupled to the conductive component E₁ 1128 of charge distribution structure 1174, and to the source terminal of transistor Q_{2,1} 1138, and to the drain terminal of transistor Q_{1,0} 1144 at junction J₁ 1166.

The example of Fig. 11 shows transistor Q_{D,3} 1178 coupled between the drain terminal 1152 of transistor Q_{HV} 1150 and conductive component E₃ 1116 of charge distribution structure 1174. The voltage between the drain terminal 1152 of transistor Q_{HV} 1150 and conductive component E₃ 1116 of charge distribution structure 1174 is the drain-to-source voltage V_{D,3} 1176 of transistor Q_{D,3} 1178. The drain terminal of transistor Q_{D,3} 1178 is coupled to the drain terminal 1152 transistor Q_{HV} 1150. The source terminal of transistor Q_{D,3} 1178 is coupled to the conductive component E₃ 1116 of the charge distribution structure 1174 and to the drain terminal of transistor Q_{3,2} 1134 at the junction J₃ 1180. The gate terminal of transistor Q_{D,3} 1178 is coupled to the conductive component E₂ 1122 of charge distribution structure 1174, and to the source terminal of transistor Q_{3,2} 1134, and to the drain terminal of transistor Q_{2,1} 1138 at the junction J₂ 1168.

When transistor Qi,o 1144 turns on to discharge capacitance Ci,o 1130 associated with conductive component E₁ 1128, transistors Q_{2,1} 1138 and Q_{3,2} 1134 and Q_{D,3} 1178 also turn on to discharge capacitances C_{2,1} 1124, C_{3,2} 1118, and C_{D,3} 1112 associated with the respective conductive components E₂ 1122 and E₃ 1116. Therefore, when high voltage transistor Q_{HV} 1150 turns on, transistors of the static discharge system 1102 set the voltages on the conductive components of the charge distribution structure 1174 to approximately the potential of the common return 1110, effectively removing accumulated static charge from the conductive components of the charge distribution structure 1174.

When transistors Q_{HV} 1150 and Qi,o 1144 turn off and the voltage V_{HV} 1154 increases, the voltages on the conductive components E₁ 1128, E₂ 1122, and E₃ 1116 of charge distribution structure 1174 will increase to reach or exceed a magnitude that turns off transistors Q_{2,1} 1138, Q_{3,2} 1134, and Q_{D,3} 1178. The voltage on conductive components E₁ 1128, E₂ 1122, and E₃ 1116 of charge distribution structure 1174 is limited to a fraction of the voltage V_{HV} 1154 as determined by the voltage divider circuit formed by the resistors R_{D,3} 1114, R_{3,2} 1120, R_{2,1} 1126, and Ri,o 1132 and/or capacitances C_{2,1} 1124, C_{3,2} 1118, and C_{D,3} 1112.

In a typical design, when transistor Q_{HV} 1150 is off and V_{HV} 1154 is hundreds of volts, the voltage between any two adjacent conductive components of the charge distribution structure 1174, will be between 10 and 200 volts. At the same time, the voltage between conductive component E₁ 1128 of charge distribution structure 1174 and the gate 1156 of transistor Q_{HV} 1150, will also be between 10 and 200 volts. In other words, the voltages V_{D,3} 1176, V_{3,2} 1136, V_{2,1} 1140, and V_{1,0} 1146 when transistor Q_{HV} 1150 is off will be sufficient to turn off transistors Q_{D,3} 1178 and Q_{3,2} 1134 and Q_{2,1} 1138. Therefore, when high voltage is present between the drain terminal 1152 and the source terminal 1158 of high voltage transistor Q_{HV} 1150, all transistors in the static discharge system 1102 will be off, providing minimum leakage current through the discharge system 1102 and, therefore, minimum voltage drop across the load resistor R 1106.

In other words, depletion mode devices are coupled to floating conductors of a charge distribution structure included in a semiconductor device. When the semiconductor device is on, the difference in voltage between the floating conductors is sufficiently low to turn on the depletion mode devices. When the semiconductor device is off, the difference in voltage between the floating conductors is sufficiently high to turn off the depletion mode devices.

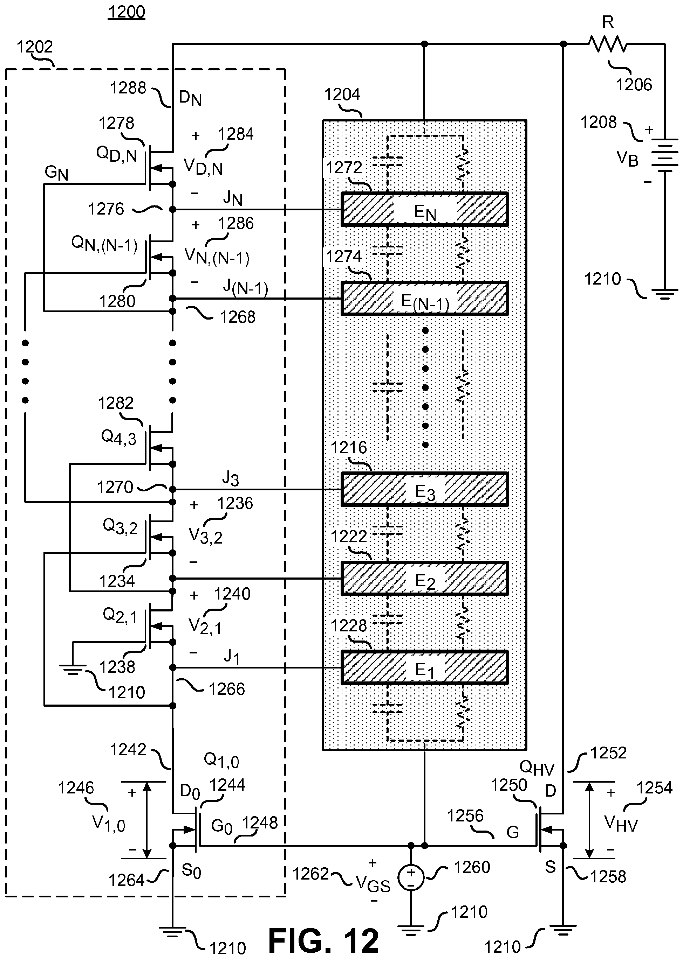

Fig. 12 is an electrical schematic diagram 1200 that shows how the example static discharge system of Fig. 11 may be expanded to accommodate a general charge distribution system that has N elements. In the example of Fig. 12, transistor Q_{HV} 1250 is a high voltage HFET with a drain terminal 1252, a source terminal 1258, and a gate terminal 1256. An internal charge distribution structure between the drain terminal 1252 and the gate terminal 1256 of transistor Q_{HV} 1250 includes conductive components E₁ 1228, E₂ 1222, E₃ 1216, E_{(N-1)} 1274, and E_{N} 1272 surrounded by an imperfect electrically insulating material 1204.

In the general example of Fig. 12, the drain terminal D 1252 of high voltage HFET Q_{HV} 1250 is coupled to one end of a resistor R 1206 and to the drain D_{N} 1288 of a transistor Q_{D,N} 1278 in a static discharge system 1202. The other end resistor R 1206 is coupled to the positive terminal of a constant voltage source V_{B} 1208. The negative terminal of the constant voltage source V_{B} 1208 is coupled to a common return 1210. The source terminal S 1258 of high voltage HFET Q_{HV} 1250 is also coupled to the common return 1210. A variable voltage source 1260 that produces a switching control voltage V_{GS} 1262 is coupled between the gate terminal G 1256 of high voltage HFET Q_{HV} 1250 and the common return 1210. As in the example of Fig. 11, high voltage HFET Q_{HV} 1250 operates as a switch that produces a switching voltage V_{HV} 1254 between the drain terminal 1242 and the source terminal 1258.

The general example of Fig. 12 also shows the static discharge system 1202 that includes transistors Q_{1,0} 1244, Q_{2,1} 1238, Q_{3,2} 1234, Q_{4,3} 1282, Q_{N,(N-1)} 1280, and Q_{D,N} 1278. As in the example of Fig. 11, all transistors in the general example of Fig. 12 are depletion mode HFETs.

Transistor Qi,o 1244 in the static discharge system of Fig. 12 has a gate terminal G 1248 coupled to the gate terminal 1256 of high voltage transistor Q_{HV} 1250. Transistor Q_{1,0} has a source terminal So 1264 coupled to common return 1210. Drain terminal Do 1242 of transistor Q_{1,0} 1244 is coupled at a junction J₁ 1266 to the source terminal of transistor Q_{2,1} 1238 and to the gate terminal of transistor Q_{3,2} 1234, and to the conductive component E₁ 1228. The gate terminal of transistor Q_{2,1} 1238 is coupled to the common return 1210. The drain terminal of transistor Q_{2,1} 1238 is coupled to the source terminal of transistor Q_{3,2} 1234, to the gate terminal of transistor Q_{4,3} 1282, and to the conductive component E2 1222.

The voltage between conductive component E₁ 1228 and the common return 1210 is the voltage Vi,o 1246 between the drain terminal Do 1244 and the source terminal So 1264 of transistor 1244. The voltage between conductive components E₂ 1222 and E₁ 1228 is the voltage V_{2,1} 1240 between the drain terminal and the source terminal of transistor Q_{2,1} 1238. The voltage between conductive components E₃ 1216 and E₂ 1222 is the voltage V_{3,2} 1236 between the drain terminal and the source terminal of transistor Q_{3,2} 1234.

The general example of Fig. 12 shows the drain terminal D_{N} 1288 of transistor Q_{D,N} 1278 coupled to the drain terminal D 1252 of high voltage HFET Q_{HV} 1250. The source terminal of transistor Q_{D,N} 1278 in the general example of Fig. 12 is coupled to conductive component E_{N} 1272 and to the drain terminal of transistor Q_{N,(N-1)} 1280 at a junction J_{N} 1276. The source terminal of transistor Q_{N,(N-1)} 1280 is coupled to conductive component E_{(N-1)} 1274 and to the gate terminal of transistor Q_{D,N} 1278 at a junction J_{(N-1)} 1268. The voltage between conductive components E_{N} 1272 and E_{(N-1)} 1274 is the voltage V_{N,(N-1)} 1286. The voltage between the drain D 1252 of transistor Q_{HV} 1250 and conductive component E_{N} 1272 is V_{D,N} 1284.

Fig. 12 shows that the static discharge system 1202 may be applied to a charge distribution structure that is part of a high voltage HFET, the charge distribution structure having N conductive components designated as E₁ through E_{N} with conductive component E₁ nearest the gate terminal of the HFET and conductive component E_{N} nearest the drain terminal of the HFET. For non-trivial examples where N>1, the conductive components may be arranged so that for any two conductive components E_{K} and E_{(K-1)}, the conductive component E_{K} is nearer to the drain terminal of the high voltage HFET than the conductive component E_{(K-1)}, where K is an integer greater than one and less than or equal to N. Stated symbolically, in the preceding description K is an integer with 1<K≤N.

Fig. 12 also shows that low voltage HFETs of the static discharge system 1202 may be coupled between the conductive components of the charge distribution structure to realize a circuit that has the drain terminal of a low voltage HFET Q_{K,(K-1)} coupled to conductive component E_{K}, and the source terminal of the low voltage HFET Q_{K,(K-1)} coupled to conductive component E_{(K-1)} at a junction J_{(K-1)}. The circuit further has the gate terminal of the low voltage HFET Q_{K,(K-1)} coupled to the junction J_{(K-2)}. For the special case of K=2, the circuit has the gate terminal of HFET Q_{K,(K-1)} coupled to the source terminal of the high voltage HFET. The general static discharge structure of Fig. 12 shows that a low voltage HFET Q_{D,N} may be coupled between the drain terminal of the high voltage HFET and the conductive component E_{N} of the static discharge system.

Fig. 12 also shows that the general example circuit of a static discharge system 1202 includes an additional low voltage HFET coupled with its drain terminal to conductive component E₁, its source terminal coupled to the source terminal of the high voltage HFET, and its gate terminal coupled to the gate terminal of the high voltage HFET. Thus as illustrated by the general example of Fig. 12, a static discharge system for a high voltage HFET may include one low voltage HFET for every conductive component of a charge distribution structure that is part of the high voltage HFET. For the trivial case of only a single conductive component in the charge distribution structure (N=1 and K=0), the static discharge system reduces to the single transistor Qi,o 1244.

Therefore, Fig. 12 shows an example of a semiconductor circuit comprising a three terminal semiconductor device 1250, a surface charge distribution structure 1204 having a plurality of conductors with a floating potential (1228, 1222, 1216, 1274, and 1272), being capacitively coupled to a terminal of the semiconductor device, and a static discharge system 1202 for removing charge that accumulates on the conductors when the semiconductor device is in a first (off) state while allowing charge to accumulate on the conductors when the semiconductor device is in a second (on) state.

It will be appreciated by those skilled in the art that the difference in voltage between the conductive components of the charge distribution structure 1204 when the high voltage transistor Q_{HV} 1250 is off depends on the number N of conductive components and the relative spacing between the conductive components. The voltage between adjacent conductive components may be reduced with larger N and reduced spacing. In examples where the voltage between adjacent conductive components of the charge distribution structure 1204 is not large enough to turn off the transistors of the static discharge system 1202, the gates of the low voltage HFETs may be coupled to conductive components that are farther away from the sources of their respective HFETs. In other words, the gate terminal of a low voltage HFET Q_{K,(K-1)} may be coupled to a junction J_{(K-2-M)} where M is an integer greater than equal to one.

The transistors of the static discharge system may be fabricated using the same process as the semiconductor device that includes the charge distribution system. Moreover, the static discharge system may be fabricated on the same substrate as the semiconductor device that includes the charge distribution system and simultaneously with the semiconductor device that includes the charge distribution system.

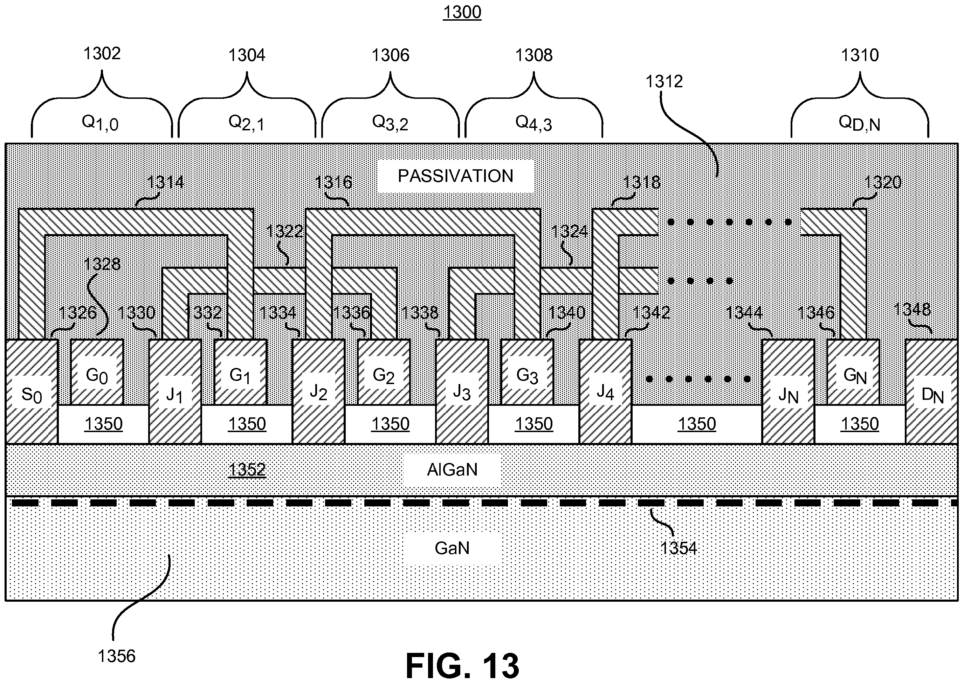

Fig. 13 shows the salient features of a general example of a static discharge system. In particular, Fig. 13, which is not drawn to scale, is a cross-sectional view 1300 through one part of a static discharge system that includes several heterostructure field effect transistors (HFETs). The schematic diagram of the static discharge system 1202 of Fig. 12 is representative of the cross section of the semiconductor construction illustrated in Fig. 13.

The example static discharge system illustrated in Fig. 13 comprises a first active layer 1356 and a second active layer 1352. The first active layer 1356 is typically disposed over a substrate (not shown in Fig. 13) that may be formed from various materials such as sapphire (Al₂O₃), silicon (Si), or silicon carbide (SiC) as is known in the art. Various techniques of fabrication may call for layers of other materials to be disposed between the substrate and the first active layer 1356 to facilitate the construction of the device.

The first active layer 1356 in the example of Fig. 13 is comprised of gallium nitride (GaN). In other examples, different semiconductor materials containing nitride compounds of other elements from Group III of the Periodic Table of the Elements may comprise the first active layer 1356.

The second active layer 1352 in the example of Fig. 13 is comprised of aluminum gallium nitride (AlGaN). In other examples, different Group III nitride semiconductor materials such aluminum indium nitride (AlInN) and aluminum indium gallium nitride (AlInGaN) may comprise the second active layer 1352. The material of the second active layer 1352 may be a non-stoichiometric compound. In such materials, the ratios of the elements are not easily represented by ordinary whole numbers. For example, the second active layer 1352 may be a non-stoichiometric compound of a Group III nitride semiconductor material such as Al_{X}Ga_{1-X}N where 0<X<1.

In the example of Fig. 13, a conductive source contact 1326, a conductive drain contact 1348, and conductive gate contacts 1328, 1332, 1336, 1340, and 1346 are disposed over the second active layer 1352. Also disposed over the second active layer 1352 are conductive junction contacts 1330, 1334, 1338, 1342, and 1344. As used in this disclosure, a junction contact joins the source contact of a transistor to the drain contract of a neighboring transistor.

Also in the example of Fig. 13, a gate dielectric layer 1350 separates the gate contacts 1328, 1332, 1336, 1340, and 1346 from the second active layer 1352. A dielectric is an electrically insulating material that can be polarized by an external electric field. Polarization orients bound electric charge in the material to make the magnitude of the electric field inside the material less than the magnitude of the external electric field.

The source, gate, junction, and drain contacts shown in the example of Fig. 13 are parts of several individual transistors of a static discharge structure 1202 as described in the electrical schematic of the general example of Fig. 12. The source So 1326, the gate G₀ 1328, and junction J₁ 1330 are respectively source, gate, and drain terminals of HFET Q_{1,0} 1302. Similarly, junction contact J₁ 1330, gate contact G₁ 1332, and junction contact J₂ 1334 are respectively the source, gate and drain terminals of HFET Q_{2,1} 1304. Junction contacts J₂ 1324, J₃ 1338, J₄ 1342, and J_{N} 1344 with gate contacts G₂ 1336, G₃ 1340, G_{N} 1346 plus drain contact D_{N}1348 form HFETs Q_{3,2} 1306, Q_{4,3} 1308, and Q_{D,N} 1310.

The example HFETs depicted in Fig. 13 are also known as high electron mobility transistors (HEMTs). In the HEMTs of Fig. 13, the second active layer 1352, which generally has a higher bandgap than the first active layer 1356, gives rise to a layer of electric charge 1354 in the first active layer 1356 near the second active layer 1352. The layer of electric charge 1354 defines a lateral conductive channel. The first active layer 1356 is sometimes called the channel layer. The second active layer 1352 is sometimes called the barrier layer or the donor layer. The layer of electric charge1354 which defines the lateral conductive channel is sometimes called a two-dimensional electron gas (2DEG) because electrons, trapped in the quantum well that results from the difference in the bandgaps, are free to move in two dimensions but are tightly confined in the third dimension.

In the operation of an HFET, for example Q_{1,0}, electric charge in the two-dimensional electron gas 1354 moves in a channel between the source contact So 1326 and the drain contact J₁ 1330 to become a current in an external circuit. The electric charge, and hence the current, is controlled by a voltage from an external circuit that is electrically connected between the gate contact G₀ 1328 and the source contact So 1326.

The example static discharge structure of Fig. 13 shows electrical connections between source, gate, and junction contacts. As used in this disclosure, an electrical connection is an ohmic connection. An ohmic connection is one in which the relationship between the voltage and the current is linear and symmetric for both directions of the current. For example, two metal patterns that contact each through only metal are electrically connected. In contrast, the junction contact J₁ 1330 and the source contact S₀ 1330 are not electrically connected in the example of Fig. 13 because any connection between these contacts is through a channel in the semiconductor and controlled by the gate contact G₀ 1328. Similarly, the gate contact G₀ 1328 is not electrically connected to the semiconductor 1352 under the gate contact G₀ 1328, and the gate contact G₀ 1328 is not electrically connected to the2DEG 1354 when a gate dielectric 1350 is used to insulate the gate contact G₀ 1328 from the semiconductor 1352 beneath.

A passivation layer 1312 of a dielectric material is disposed around the contacts and above the gate dielectric layer 1312 in the example of Fig 13. The passivation layer 1312 provides stability of the electrical characteristics of the device by isolating the surface of the device from electrical and chemical contaminants in the environment. The passivation layer 1312 may be deposited in more than one step to allow for metal to be embedded within the passivation material.

In other examples that use different arrangements of passivation layers, the gate dielectric layer 1350 is optional. In examples without the gate dielectric layer 1350, the gate contacts G₀ 1328, G₁ 1332, G₂ 1336, G₃ 1340, and G_{N} 1346 each form a Schottky contact to the second active layer 1352. A Schottky contact is a junction between a metal and a semiconductor that conducts current between the metal and the semiconductor in only one direction. Transistors without the gate dielectric layer are sometimes called Schottky gate transistors. An example of a construction that uses an optional gate dielectric layer is presented later in this disclosure.

The passivation 1312 in the example of Fig. 13 is transparent, giving visibility to objects that lie behind the plane of the cross-section. For example, the metal 1322 that makes an electrical connection between junction contact J₁ 1330 and gate contact G₂ 1336 is in a plane behind metal 1314 and metal 1316. Metal 1324 is behind metal 1316 and metal 1318. The metal 1318 that makes an electrical connection to junction contact J₄ 1342 would make an electrical connection with a gate G₅ not shown in the example of Fig. 13. The metal 1320 that makes an electrical connection to the gate contact G_{N} 1346 would make an electrical connection with a junction contact J_{(N-1)} not shown in the example of Fig. 13.

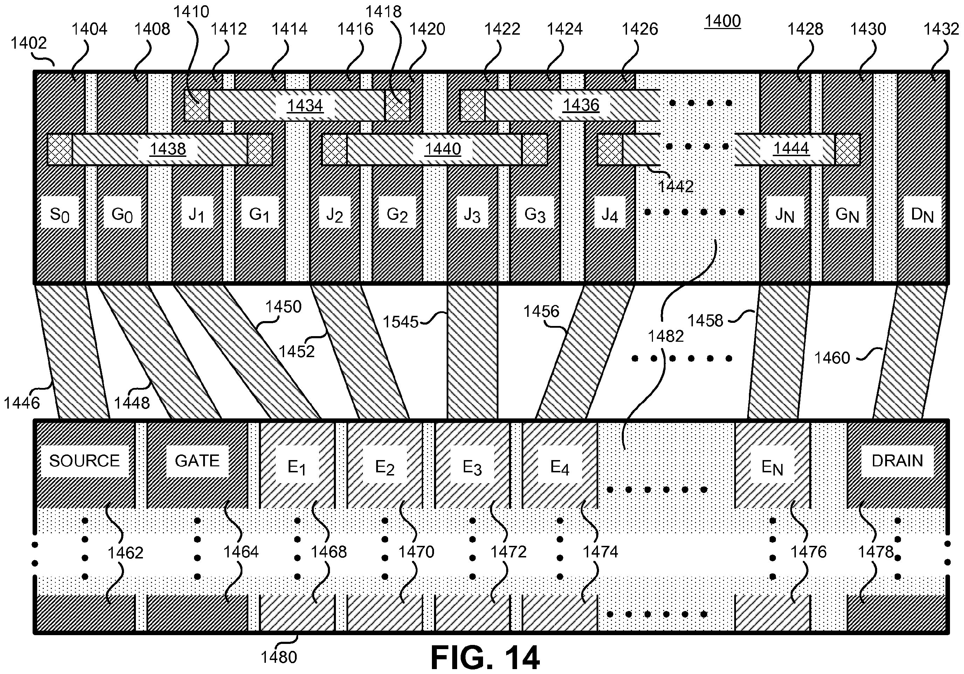

Fig. 14 is a top view 1400 that shows the example static discharge system of Fig. 13 with a high voltage power HFET 1480. The static discharge system 1402 and the high voltage power HFET 1480 in the example of Fig. 14 may be fabricated as separate devices on the same semiconductor substrate as will be described in detail later in this disclosure. The passivation material in the example static discharge system of Fig. 13 is transparent in the view of Fig. 14, providing visibility to the gate dielectric 1482 and to various conductive components. The elements of Fig. 14 are not shown to scale.

The high voltage power HFET 1480 in the example of Fig. 14 has a significant section of its interior removed to emphasize that the high voltage power HFET 1480 is typically substantially larger than the static discharge system 1402. In practice, the width of the conducting channel of each transistor in the static discharge system 1402 may be less than 2% of the width of conducting channel in the high voltage power HFET 1480. The transistors in the static discharge system 1402 must be only large enough to conduct the accumulated charge from the components of the charge distribution structure during the transitions in voltage on the high voltage power HFET 1480. The high voltage power HFET 1480 includes a source contact 1462, a gate contact 1464, a drain contact 1478, and a charge distribution structure with conductive components E₁ 1468, E₂ 1470, E₃ 1472, E₄ 1474, and E_{N} 1476.

The top view of the example static discharge system 1402 shown in Fig. 14 reveals the layout of the metal that makes electrical connections between contacts of the low voltage HFETs. The example of Fig. 14 shows metal 1438 connecting source contact So 1404 to gate contact G₁ 1414, metal 1434 connecting junction contact J₁ 1412 to gate contact G₂ 1418, and metal 1440 connecting junction contact J₂ 1416 to gate contact G₃ 1424. Metal 1436 would connect junction contact J₃ 1422 to gate contact G₄ not shown in Fig. 14. Metal 1442 would connect junction contact J₄ 1426 to gate contact G₅ not shown in Fig. 14. Metal 1444 would connect gate contact G_{N} 1430 to junction contact J_{(N-1)} not shown in Fig. 14.

The horizontal sections of the metal 1434, 1436, 1438, 1440, and 1444 of the static discharge structure shown in Fig. 14 connect at their ends to vertical sections of metal not visible in Fig. 14. The vertical sections of metal connect to the contacts directly below the ends of the horizontal sections of metal. For example, horizontal metal section 1434 connects to a vertical metal section 1410 at one end that in turn connects to junction contact J₁ 1412, and horizontal metal section 1434 connects to a vertical metal section 1418 at its other end that in turn connects to gate contact G₂ 1420.

The example of Fig. 14 also shows connections between the static discharge system 1402 and the high voltage HFET 1480. Metal 1446 connects the source contact So 1404 of the static discharge system 1402 to the source contact 1462 of the high voltage HFET 1480. Metal 1448 connects the gate contact G₀ 1408 of the static discharge system 1402 to gate contact 1464 of the high voltage HFET 1480. Metal 1450 connects the junction contact J₁ 1412 of the static discharge system 1402 to the conductive component E₁ 1468 of the charge distribution structure of the high voltage HFET 1480. Metal 1452 connects the junction contact J₂ 1416 and to conductive component E₂ 1470 of the charge distribution structure of the high voltage HFET 1480. Metal 1454 connects the junction contact J₃ 1422 to the conductive component E₃ 1472 of the charge distribution structure of the high voltage HFET 1480. Metal 1456 connects the junction contact J₄ 1426 to the conductive component E₄ 1474 of the charge distribution structure of the high voltage HFET 1480. Metal 1458 connects the junction contact J_{N} 1428 to the conductive component E_{N} of the charge distribution structure of the high voltage HFET 1480. Metal 1460 connects the drain contact D_{N} 1432 to the drain contact 1478 of the high voltage HFET 1480.

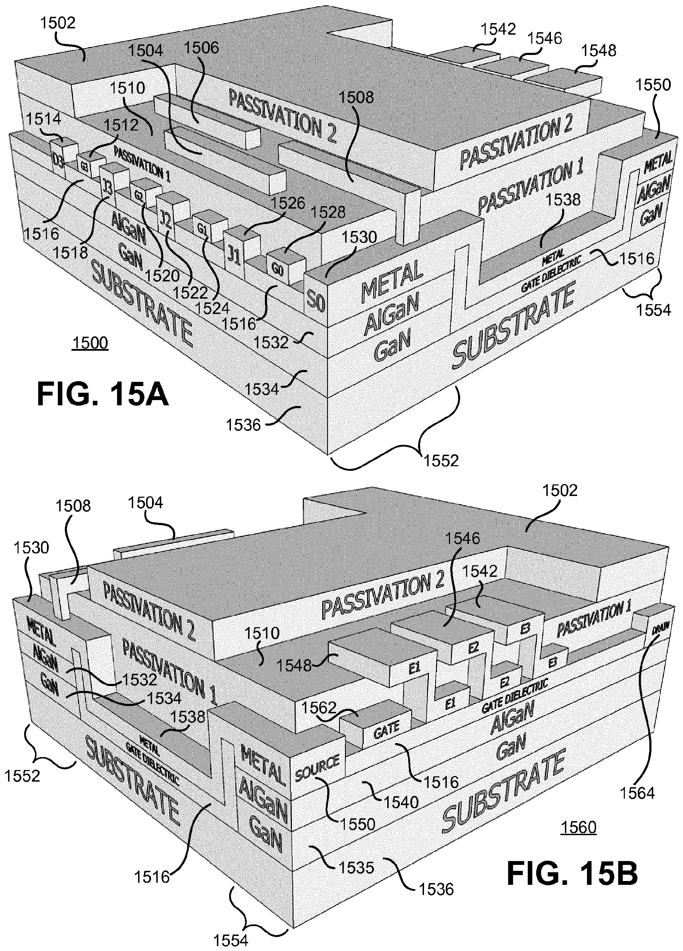

Fig. 15A is a perspective view 1500 showing the relative positions of various parts and features of an example static discharge system including a high voltage power HFET that has a charge distribution structure. Fig. 15B is a different perspective view 1560 of the static discharge system shown in Fig. 15A. The example semiconductor device shown in Fig. 15A and Fig. 15B is similar to the example device described the in the cross-section view of Fig. 13 and in the top view of Fig. 14, and is represented in the electrical schematic diagram of Fig. 11

The perspective views of Fig. 15A and Fig. 15B, and all other perspective views presented in this disclosure may not be drawn to scale. Some dimensions may have been exaggerated to show details that would not be visible in a scaled drawing.

Fig. 15A and Fig. 15B illustrate how a static discharge system may be assembled with a high voltage HFET on the same substrate. Low voltage HFETs for the static discharge system may be fabricated with the same process and at the same time as the high voltage HFET. The static discharge system and the high voltage HFET may be fabricated as independent devices that are electrically coupled only through conductors that span the distance between the devices on the substrate.

Metal that connects contacts of the low voltage transistors and that connects the low voltage transistors to the charge distribution structure of the high voltage HFET may deposited at the same time as the metal that forms the charge distribution structure of the high voltage HFET. Portions of some layers of the example device have been removed in Fig. 15A and Fig. 15B to expose underlying features in greater detail. All layers would normally cover the entire device, ending at the same vertical plane on each side of the device.

Fig. 15A and Fig. 15B show the structures of an example static discharge system 1552 and a portion 1554 of a high voltage HFET. The example static discharge system 1552 and the portion of the high voltage HFET 1554 are on the same substrate 1536, but they have independent active areas. The active areas are the regions of the active layers under the contacts that take part in the operation of the devices. The portion of the HFET 1554 visible in the perspective drawings of Fig. 15A and Fig. 15B may represent typically less than 2% of the high voltage transistor.

In the example illustrated in Fig. 15A and Fig. 15B, the first active layer 1534 of the static discharge system 1552 and the first active layer 1535 of the high voltage HFET 1554 are of the same material composition, but the two first active layers are spatially separated from each other by a region where there is no first active layer. Also in the example illustrated in Fig. 15A and Fig. 15B, the second active layer 1532 of the static discharge system 1552 and the second active layer 1540 of the high voltage HFET 1554 are of the same material composition, but the two second active layers are spatially separated from each other by a region where there is no second active layer. Therefore, the transistors of the static discharge system 1552 may operate independently from the high voltage HFET 1554 even though all the devices are fabricated on the same substrate 1536.

Consistent with the cross-section representation of Fig. 13 and the top view of Fig 14, the perspective views of Fig. 15A and Fig. 15B show for the static discharge system a first active layer 1534, a second active layer 1532, and a dielectric layer 1516 above a substrate 1536. Fig. 15A and Fig. 15B also show for the high voltage HFET 1554 a first active layer 1535, a second active layer 1540, and the dielectric layer 1516 above the substrate 1536. In the example of Fig. 15A and Fig. 15B, the dielectric layer 1516 is continuous over the area of the static discharge system 1552, the high voltage HFET 1554, and the region where there are no active layers. Fig. 15A and Fig 15B show conductive contacts for sources, gates, and drains of four low voltage HFETs and one high voltage HFET.

The example of Fig. 15A and Fig. 15B shows the gate dielectric 1516 deposited over the second active layer 1532 in the region of the static discharge system 1552 and over the second active layer 1540 in the region of the high voltage HFET 1554. The gate dielectric layer 1516 visible in Fig. 15A in the region of the static discharge system 1552 corresponds to the region 1350 in the cross-sectional view of the example of Fig. 13. The passivation 1312 shown in the example cross-sectional view of the example of Fig. 13 corresponds to a first passivation layer 1510 and a second passivation layer 1502 in the example of Fig. 15A and Fig. 15B to indicate that the example the passivation is deposited in two steps of the fabrication process.

Contacts for terminals of the high voltage HFET 1554 are visible in the perspective view of Fig. 15B as the source 1550, the gate 1562, and the drain 1564. The perspective views of Fig. 15A and Fig. 15B also show conductive components E₁ 1548, E₂ 1546 and E₃ 1542 of a charge distribution structure within the region of high voltage HFET 1554. The conductive components E₁ 1548, E₂ 1456, and E_{N} 1542 may be formed from an electrically conducting material or materials such as one or more metals, heavily doped semiconductors, and the like.

Horizontal components of the charge distribution structure are fabricated from conductive material of appropriate thickness, appearing as stripes in a conventional two-dimensional view from the top. In one example, the thickness of the stripes may be approximately the same dimension as the width of the stripes. While the examples discussed herein refer to the horizontal components as stripes, more generally the horizontal components may be elongate members having a wide variety of different cross-sectional shapes.

Fig. 15A and Fig. 15B reveal that the conductive components E₁ 1548, E₂ 1546 and E₃ 1542 of the charge distribution structure are formed from horizontal top stripes and horizontal bottom stripes that are connected with vertical conducting pillars through the first passivation layer 1510. Contacts for terminals of low voltage HFETs in the region of the static discharge structure 1552 are visible in the perspective view of Fig. 15A as source contact So 1530, drain contact D₃ 1514, junction contacts J₁ 1526, J₂ 1522, J₃ 1518, and gate contacts G₀ 1528, G₁ 1524, G₂ 1520, and G₃ 1512.

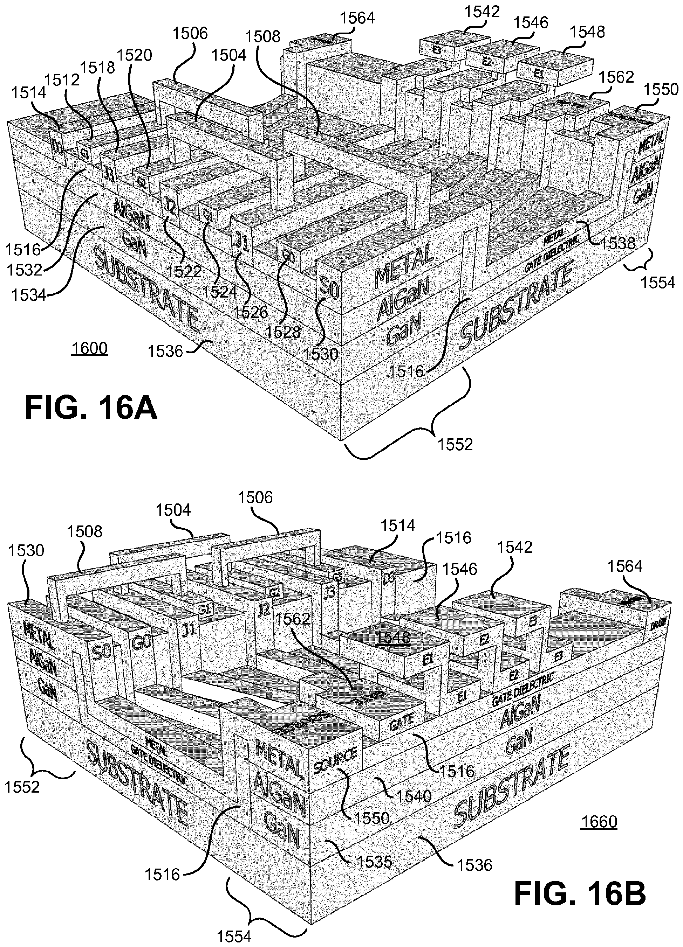

The contacts of the transistors in the example illustrated in the perspective views of Fig. 15A and Fig. 15B are connected with deposits of metal. For example, the metal 1504 connects junction contact J₁ 1526 to gate contact G₂ 1520. The metal 1506 connects junction contact J₂ 1522 to gate contact G₃ 1512. The metal 1508 connects gate contact G₁ 1524 to source contact S₀ 1530. The metal 1538 connects source contact S₀ 1530 of the static discharge system 1552 to source contact 1550 of the high voltage HFET 1554. The first passivation layer 1510 and the second passivation layer 1502 are removed in the perspective views of Fig. 16A and Fig. 16B to reveal more of the metal in the examples of Fig. 15A and Fig. 15B.

Fig. 16A is a perspective view 1600 that shows the example static discharge system of Fig. 15A with passivation layers 1510 and 1502 removed to show additional detail. Fig. 16B is a different perspective view 1660 of the example static discharge system shown in Fig. 16A. Fig. 16A and Fig. 16B reveal the conductors under the passivation and above the gate dielectric 1516 that occupies the space between the region of the static discharge system 1552 and the high voltage HFET 1554 on the substrate 1536.

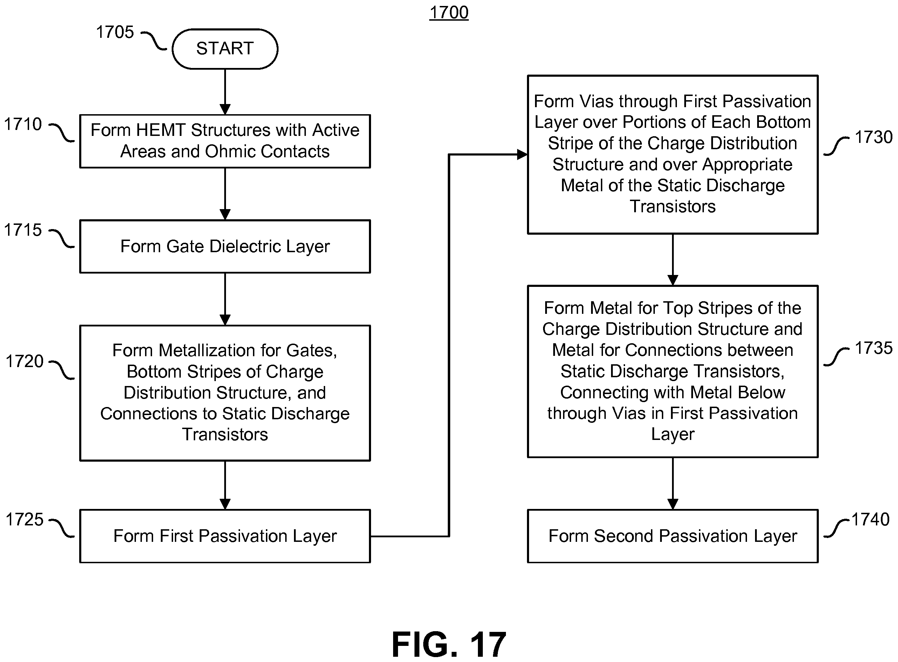

Fig. 17 is an example flow diagram illustrating generally a sample flow of operations in an example process to construct the example semiconductor device illustrated in Fig. 15A and Fig. 15B. After starting in block 1705, structures for high electron mobility transistors (HEMTs) are formed in block 1710 with active areas and ohmic contacts for the drains and the sources as is known in the art. A gate dielectric layer is then formed over the active areas in step 1715.

After the gate dielectric layer is formed in block 1715, metallization for the gates of the HEMTs, metallization for the bottom stripes of the charge distribution structure, and metallization for the connections between the high voltage HFET and the transistors of the static discharge system are formed over the gate dielectric layer in block 1720. Next, in block 1725, a first passivation layer is formed over the metal previously deposited.

Vias are then formed through the first passivation layer in block 1730 where it is desired to join the bottom stripes with the top stripes to form components of the charge distribution structure. Vias are also formed over appropriate portions of the transistors in the static discharge system to provide connections between them as described above. Metal is then deposited in block 1735 on the surface of the first passivation layer and through the vias in the first passivation layer to form top stripes of the charge distribution structure that are joined to bottom stripes of the charge distribution structure. Metal is also deposited on the surface of the first passivation layer and through the vias in the first passivation layer to form connections between the static discharge transistors. The process ends with the formation of a second passivation layer in block 1740.

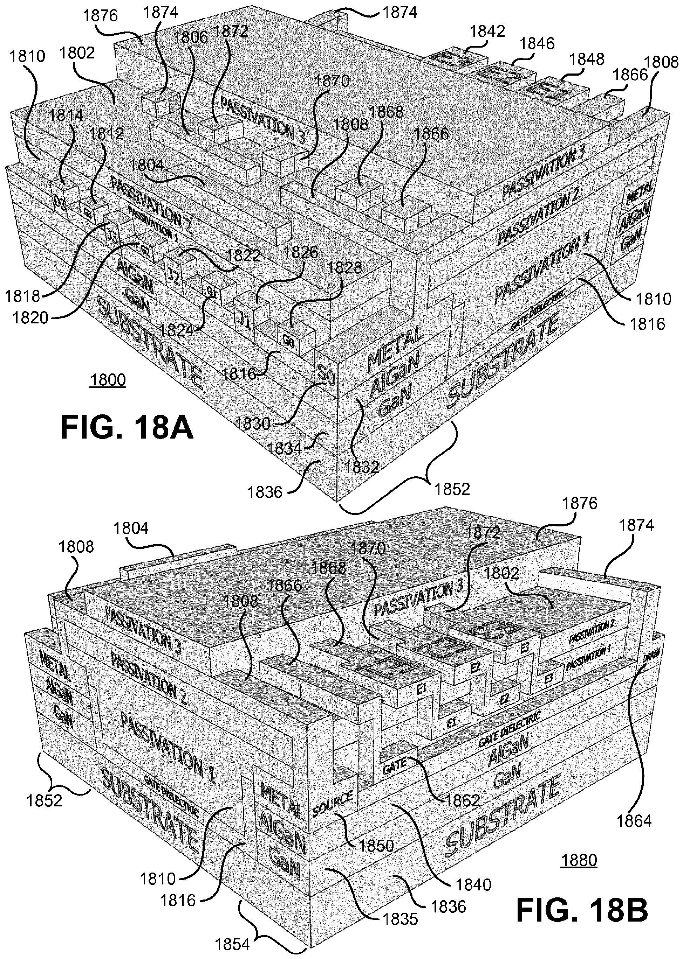

Fig. 18A is a perspective view 1800 showing the relative positions of various parts and features of another example static discharge system 1852 sharing a substrate 1836 with a high voltage HFET 1854 (see Fig. 18B) that includes a charge distribution structure. Fig. 18B is a different perspective view 1880 of the device shown in Fig. 18A. The example static discharge system 1852 shown in Fig. 18A and Fig. 18B has an additional layer of passivation 1810 that allows an optional gate dielectric layer 1816, whereas the gate dielectric layer 1516 is mandatory in the structure illustrated in Fig. 15A, Fig. 15B, Fig. 16A, and Fig. 16B. In examples without the optional gate dielectric layer 1816, the gate contact 1862 forms a Schottky contact to the second active layer 1840, and the passivation layer 1810 insulates the components E₁ 1868, E₂ 1870, and E₃ 1872 of the charge distribution structure from the second active layer 1840.

Fig. 18A and Fig. 18B illustrate how a static discharge system 1852 may be assembled on the same substrate as a high voltage HFET 1854 during the fabrication of the HFET 1854. As in Fig. 15A and Fig. 15B, portions of some layers of the example device have been removed in Fig. 18A and Fig. 18B to expose underlying features in greater detail.

Similar to the views of Fig. 15A and Fig. 15B, the perspective views of Fig. 18A and Fig. 18B show a static discharge system 1852 and a portion of a high voltage HFET 1854. The perspective views of Fig. 18A and Fig. 18B show for the static discharge system 1852 a first active layer 1834, a second active layer 1832, and an optional dielectric layer 1816 above a substrate 1836. Fig. 18A and Fig. 18B also show for the high voltage HFET 1854 a first active layer 1835, a second active layer 1840, and the optional dielectric layer 1816 above the substrate 1836. Fig. 18A and Fig. 18B show that the two active areas of the static discharge system 1852 are spatially separated from the two active areas of the high voltage HFET 1854 by a region where there are no active layers.

In the example of Fig. 18A and Fig. 18B, the optional dielectric layer 1816 is continuous over the area of the static discharge system 1852, the high voltage HFET 1854, and the region where there are no active layers. Fig. 18A and Fig 18B show conductive contacts for sources, gates, and drains of four low voltage HFETs and one high voltage HFET as illustrated in the schematic diagram of Fig. 11.

The example of Fig. 18A shows the optional gate dielectric 1816 deposited over the second active layer 1832 in the region of the static discharge system 1852, and Fig. 18B shows the optional gate dielectric 1816 deposited over the second active layer 1840 in the region of the high voltage HFET 1854. The example of Fig. 18A and Fig. 18B also shows a first passivation layer 1810, a second passivation layer 1802, and a third passivation layer 1876 deposited over the optional gate dielectric 1816. In examples that do not use the gate dielectric 1816, gate contact 1862 is deposited directly on the second active layer 1840 to form a Schottky contact.

Contacts for terminals of the high voltage HFET 1854 are visible in the perspective view of Fig. 18B as the source 1850, the gate 1862, and the drain 1864. The perspective views of Fig. 18A and Fig. 18B also show conductive components E₁ 1848, E₂ 1846 and E₃ 1842 of a charge distribution structure within the region of high voltage HFET 1854. The conductive components E₁ 1848, E₂ 1846, and E_{N} 1842 may be formed from an electrically conducting material or materials such as one or more metals, heavily doped semiconductors, and the like.

Fig. 18A and Fig. 18B reveal that the conductive components E₁ 1848, E₂ 1846 and E₃ 1842 of the charge distribution structure are formed from horizontal top stripes and horizontal bottom stripes above and below passivation layer 1802, respectively. Contacts for terminals of low voltage HFETs in the region of the static discharge structure 1852 are visible in the perspective view of Fig. 18A as source contact So 1830, drain contact D₃ 1814, junction contacts J₁ 1826, J₂ 1822, J₃ 1818, and gate contacts G₀ 1828, G₁ 1824, G₂ 1820, and G₃ 1812.

The contacts of the transistors in the example illustrated in the perspective views of Fig. 18A and Fig. 18B are connected with deposits of metal. For example, the metal 1804 connects junction contact J₁ 1826 to gate contact G₂ 1820. The metal 1806 connects junction contact J₂ 1822 to gate contact G₃ 1812. The metal 1808 connects gate contact G₁ 1824 to source contact S₀ 1830. The metal 1808 also connects source contact S₀ 1830 of the static discharge system 1852 to source contact 1850 of the high voltage HFET 1854.

The metal 1874 connects drain contact D₃ 1814 of the static discharge system 1852 to drain contact 1864 of the high voltage HFET 1854. The metal 1872 connects junction contact J₃ 1818 of the static discharge system 1852 to conductive component E₃ 1842 of the high voltage HFET 1854. The metal 1870 connects junction contact J₂ 1822 of the static discharge system 1852 to conductive component E₂ 1846 of the high voltage HFET 1854. The metal 1868 connects junction contact J₁ 1826 of the static discharge system 1852 to conductive component E₁ 1848 of the high voltage HFET 1854. The metal 1866 connects gate contact G₀ 1828 of the static discharge system 1852 to the gate 1862 of the high voltage HFET 1854.

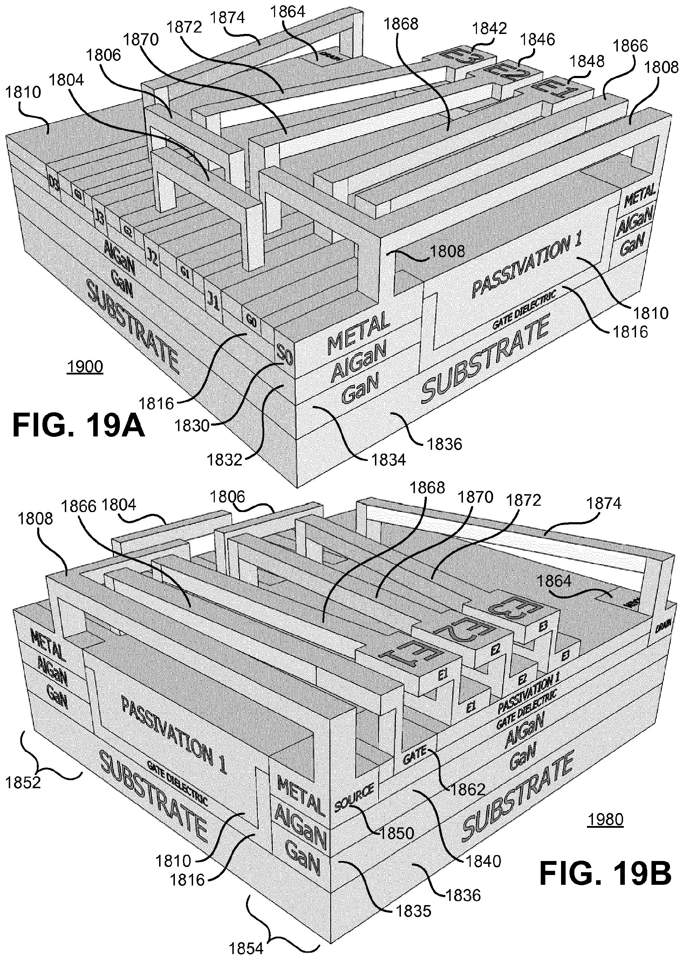

Fig. 19A is a perspective view 1900 that shows the example static discharge system of Fig. 18A with passivation layers 1802 and 1876 removed to show additional detail. Fig. 19B is a different perspective view 1980 of the example static discharge system shown in Fig. 19A. Fig. 19A and Fig. 19B reveal the metal above the first passivation layer 1810.

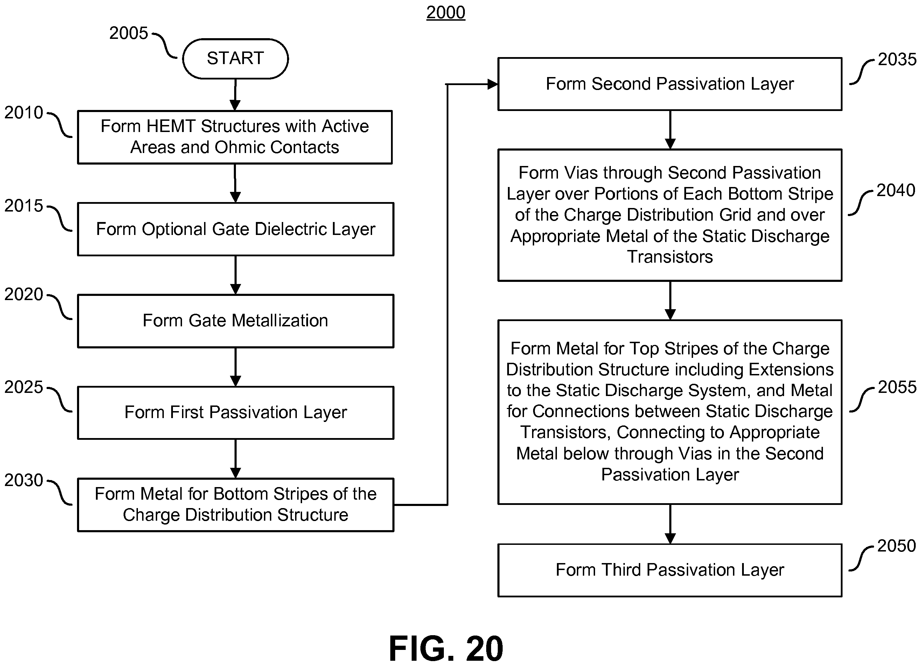

Fig. 20 is an example flow diagram illustrating generally a sample flow of operations in an example process to construct the example semiconductor device illustrated in Fig. 18A, Fig. 18B, Fig. 19A, and Fig. 19B. After starting in block 2005, structures for high electron mobility transistors (HEMTs) are formed in block 2010 with active areas and ohmic contacts for the drain and the source as is known in the art. An optional gate dielectric layer may then be formed over the active area in block 2015. Block 2015 is skipped in examples that do not use the optional gate dielectric layer.

After the completion of the operation in block 2015 in examples that use the optional gate dielectric layer, metallization for the gates is then formed in block 2020. Next, a first passivation layer is formed over the metal for the gates and the contacts for the drains and sources in block 2025. The formation of the first passivation layer may include removal of passivation material to form channels for the bottom stripes of the charge distribution structure. Then in block 2030 metal is deposited for the bottom stripes of the charge distribution structure, followed by a second passivation layer in block 2035.

Vias are then formed through the second passivation layer in block 2040 where it is desired to join the bottom stripes with top stripes to form components of the charge distribution structure and to make connections to the contacts of the static discharge structure. Metal is then deposited in block 2055 on the surface of the second passivation layer and through the vias in the second passivation layer to form top stripes of the charge distribution structure that are joined to bottom stripes of the charge distribution structure, and to form conductors that connect contacts of the static discharge system to contacts of the high voltage HFET. The process ends with the formation of a third passivation layer in block 2050.

While the teachings of the present invention have been described above in the context of an HFET, these teachings may be used with other semiconductor devices as well. For example, the surface charge distribution structure may be used with an inverted HFET, which is similar to an HFET except that the donor layer is formed below the channel layer instead of above the channel layer as in an HFET.

## Claims

1. A semiconductor circuit comprising:
a field effect transistor (1150, 1250, 1480, 1554, 1854) comprising
a plurality of semiconductor layers (1352, 1356, 1532, 1534, 1832, 1834) disposed on a substrate,
a source (1158, 1258, 1326, 1462, 1830), drain (1152, 1252, 1348, 1478, 1814), and gate (1156, 1256, 1328, 1332, 1336, 1340, 1346, 1464, 1828, 1824, 1820, 1812) electrically coupled to the semiconductor layers, and
a capacitively coupled charge distribution structure (1174, 1204) disposed over the semiconductor layers, said charge distribution structure being configured to produce a surface discharge on a surface portion of the transistor disposed between the gate and drain during a transient from an on-state to an off-state and a surface recharge on said surface portion during a transient from the off-state to the on-state;
wherein the charge distribution structure has a plurality of conductors with a floating potential; and
a static discharge system (1102, 1202, 1402, 1552, 1852) removing charge that accumulates on at least a subset of the conductors, said static discharge system removing the charge that accumulates on the subset of conductors when the semiconductor device is in a first state while allowing charge to accumulate on the subset of conductors when the semiconductor device is in a second state.

2. The semiconductor circuit of claim 1 wherein said field effect transistor has a design target switching speed, said charge distribution structure being further configured to produce the surface discharge and recharge at a rate greater than the design target switching speed.

3. The semiconductor circuit of claim 1 wherein the capacitively coupled charge distribution structure includes a metal grid having a plurality of conductive elongate members disposed over said surface portion, said conductive elongate members being capacitively coupled to one another.

4. The semiconductor circuit of claim 3 wherein the plurality of conductive elongate members define a periodically repeating structure.

5. The semiconductor circuit of claim 3 wherein the plurality of conductive elongate members includes a first set of elongate members formed in a first layer and a second set of elongate members formed in a second layer, and optionally wherein the elongate members in the first set of elongate members are parallel to one another and the elongate members in the second set of elongate members are parallel to one another.

6. The semiconductor circuit of claim 3 wherein the surface discharge removes from said surface portion at least about 90% of a maximum charge established on said surface portion, and optionally wherein the surface recharge increases charge on said surface portion to at least 90% of the maximum charge.

7. The semiconductor circuit of claim 1, wherein:
the field effect transistor is a three-terminal high voltage semiconductor device, and optionally wherein the field effect transistor is a HFET, e.g., a depletion-mode HFET.

8. The semiconductor circuit of claim 2 wherein the static discharge system includes a plurality of transistors (1178, 1134, 1138, 1144, 1278, 1280, 1282, 1234, 1238, 1244) coupled between the gate and a drain of the semiconductor device.

9. The semiconductor circuit of claim 8 wherein a source of a first of the transistors is electrically coupled to a gate of the second of the transistors and a drain of the first transistor is electrically coupled to a gate of a third of the transistors, the source of the first transistor being electrically coupled to the source of the semiconductor device and a gate of the first transistor being electrically coupled to the gate of the semiconductor device.

10. The semiconductor circuit of claim 8 wherein each of the plurality of transistors is arranged to be in an off-state when the semiconductor device is in an off-state and in an on-state when the semiconductor device is in the on-state.

11. The semiconductor circuit of claim 8 wherein each of the transistors is configured to have a lower breakdown voltage than a breakdown voltage of the field effect transistor.

12. The semiconductor circuit of claim 8 wherein the source of a transistor in the plurality of transistors in the static discharge system is coupled to a first conductor of the plurality of conductors of the charge distribution structure, the gate of the transistor being coupled to a second conductor of the plurality of conductors of the charge distribution structure, the electrical potential difference between the first conductor and the second conductor being sufficient to maintain the transistor in a second state when the semiconductor device is in the second state.

13. The semiconductor circuit of claim 8 wherein the charge distribution structure includes N conductors E₁, E₂, ... E_{N}, where N > 1, the plurality of transistors including N+1 transistors Q₁, Q₂,... Q_{N+1} such that conductor E_{K} is electrically coupled to a source of transistor Q_{K+1}, a gate of transistor Q_{K+2} and a drain of transistor Q_{K}, where 1 < K ≤ (N-1).

14. A method of forming the semiconductor circuit according to any one of claims 1 to 13, the method comprising:
forming the field effect transistor (1150, 1250, 1480, 1554, 1854) including
forming a first active layer on a substrate,
forming a second active layer over the first active layer such that the first and second active layers give rise to a two-dimensional electron gas layer between the first active layer and the second active layer,
forming source, gate and drain contacts over the second active layer, and
forming the charge distribution structure (1174, 1204) over the second active layer between the gate and drain contacts so that the charge distribution structure is capacitively coupled to a gate contact.

## Patentansprüche

1. Halbleiterschaltung, umfassend:
einen Feldeffekttransistor (1150, 1250, 1480, 1554, 1854), umfassend mehrere Halbleiterschichten (1352, 1356, 1532, 1534, 1832, 1834), die auf einem Substrat angeordnet sind, eine Source (1158, 1258, 1326, 1462, 1830), ein Drain (1152, 1252, 1348, 1478, 1814) und ein Gate (1156, 1256, 1328, 1332, 1336, 1340, 1346, 1464, 1828, 1824, 1820, 1812), die mit den Halbleiterschichten elektrisch gekoppelt sind, und eine kapazitiv gekoppelte Ladungsverteilungsstruktur (1174, 1204), die über den Halbleiterschichten angeordnet ist, wobei die Ladungsverteilungsstruktur so konfiguriert ist, dass sie eine Oberflächenentladung auf einem Oberflächenabschnitt des zwischen dem Gate und dem Drain angeordneten Transistors während eines Übergangs von einem Ein-Zustand in einen Aus-Zustand und eine Oberflächenwiederaufladung auf dem Oberflächenabschnitt während eines Übergangs von dem Aus-Zustand in den Ein-Zustand erzeugt;
wobei die Ladungsverteilungsstruktur mehrere Leiter mit einem schwebenden Potential aufweist; und
ein statisches Entladungssystem (1102, 1202, 1402, 1552, 1852), das Ladung entfernt, die sich auf mindestens einer Teilmenge der Leiter ansammelt, wobei das statische Entladungssystem die Ladung entfernt, die sich auf der Teilmenge von Leitern ansammelt, wenn sich die Halbleitervorrichtung in einem ersten Zustand befindet, während es zulässt, dass sich Ladung auf der Teilmenge von Leitern ansammelt, wenn sich die Halbleitervorrichtung in einem zweiten Zustand befindet.

2. Halbleiterschaltung nach Anspruch 1, wobei der Feldeffekttransistor eine Entwurfszielschaltgeschwindigkeit hat, wobei die Ladungsverteilungsstruktur ferner so konfiguriert ist, dass sie die Oberflächenentladung und -wiederaufladung mit einer Rate erzeugt, die größer als die Entwurfszielschaltgeschwindigkeit ist.

3. Halbleiterschaltung nach Anspruch 1, wobei die kapazitiv gekoppelte Ladungsverteilungsstruktur ein Metallgitter mit mehreren leitenden länglichen Elementen umfasst, die über dem Oberflächenabschnitt angeordnet sind, wobei die leitenden länglichen Elemente kapazitiv miteinander gekoppelt sind.

4. Halbleiterschaltung nach Anspruch 3, wobei die mehreren leitenden länglichen Elemente eine sich periodisch wiederholende Struktur definieren.

5. Halbleiterschaltung nach Anspruch 3, wobei die mehreren leitenden länglichen Elemente einen ersten Satz von länglichen Elementen, die in einer ersten Schicht gebildet sind, und einen zweiten Satz von länglichen Elementen, die in einer zweiten Schicht gebildet sind, umfassen, und wobei optional die länglichen Elemente in dem ersten Satz von länglichen Elementen parallel zueinander sind und die länglichen Elemente in dem zweiten Satz von länglichen Elementen parallel zueinander sind.

6. Halbleiterschaltung nach Anspruch 3, wobei die Oberflächenentladung von dem Oberflächenabschnitt mindestens etwa 90 % einer maximalen Ladung entfernt, die sich auf dem Oberflächenabschnitt gebildet hat, und wobei optional die Oberflächenwiederaufladung die Ladung auf dem Oberflächenabschnitt auf mindestens 90 % der maximalen Ladung erhöht.

7. Halbleiterschaltung nach Anspruch 1, wobei:
der Feldeffekttransistor ein Hochspannungs-Halbleiterbauelement mit drei Anschlüssen ist, und wobei der Feldeffekttransistor optional ein HFET, z. B. ein Verarmungs-HFET, ist.

8. Halbleiterschaltung nach Anspruch 2, wobei das statische Entladungssystem mehrere Transistoren (1178, 1134, 1138, 1144, 1278, 1280, 1282, 1234, 1238, 1244) umfasst, die zwischen dem Gate und einem Drain der Halbleitervorrichtung gekoppelt sind.

9. Halbleiterschaltung nach Anspruch 8, wobei eine Source eines ersten der Transistoren elektrisch mit einem Gate des zweiten der Transistoren gekoppelt ist und ein Drain des ersten Transistors elektrisch mit einem Gate eines dritten der Transistoren gekoppelt ist, wobei die Source des ersten Transistors elektrisch mit der Source der Halbleitervorrichtung gekoppelt ist und ein Gate des ersten Transistors elektrisch mit dem Gate der Halbleitervorrichtung gekoppelt ist.

10. Halbleiterschaltung nach Anspruch 8, wobei jeder der mehreren Transistoren so angeordnet ist, dass er sich in einem Aus-Zustand befindet, wenn sich die Halbleitervorrichtung in einem Aus-Zustand befindet, und in einem Ein-Zustand befindet, wenn sich die Halbleitervorrichtung im Ein-Zustand befindet.

11. Halbleiterschaltung nach Anspruch 8, wobei jeder der Transistoren so konfiguriert ist, dass er eine niedrigere Durchbruchspannung als eine Durchbruchspannung des Feldeffekttransistors hat.

12. Halbleiterschaltung nach Anspruch 8, wobei die Source eines Transistors bei den mehreren Transistoren in dem statischen Entladungssystem mit einem ersten Leiter der mehreren Leiter der Ladungsverteilungsstruktur gekoppelt ist, wobei das Gate des Transistors mit einem zweiten Leiter der mehreren Leiter der Ladungsverteilungsstruktur gekoppelt ist, wobei die elektrische Potentialdifferenz zwischen dem ersten Leiter und dem zweiten Leiter ausreicht, um den Transistor in einem zweiten Zustand zu halten, wenn sich die Halbleitervorrichtung in dem zweiten Zustand befindet.

13. Halbleiterschaltung nach Anspruch 8, wobei die Ladungsverteilungsstruktur Folgendes umfasst: N Leiter E1, E2, ... EN, wobei N > 1, wobei die mehreren Transistoren Folgendes umfassen: N+1 Transistoren Q1, Q2,... QN+1 so dass der Leiter EK mit einer Source des Transistors QK+1, einem Gate des Transistors QK+2 und einem Drain des Transistors QK ELEKTRISCH GEKOPPELT IST, wobei 1 < K ≤ (N-1).

14. Verfahren zum Bilden der Halbleiterschaltung nach einem der Ansprüche 1 bis 13, wobei das Verfahren Folgendes umfasst:
Bilden des Feldeffekttransistors (1150, 1250, 1480, 1554, 1854), einschließlich Bilden einer ersten aktiven Schicht auf einem Substrat, Bilden einer zweiten aktiven Schicht über der ersten aktiven Schicht, so dass die erste und die zweite aktive Schicht eine zweidimensionale Elektronengasschicht zwischen der ersten aktiven Schicht und der zweiten aktiven Schicht erzeugen, Bilden von Source-, Gate- und Drainkontakten über der zweiten aktiven Schicht, und Bilden der Ladungsverteilungsstruktur (1174, 1204) über der zweiten aktiven Schicht zwischen den Gate- und Drainkontakten, so dass die Ladungsverteilungsstruktur kapazitiv mit einem Gatekontakt gekoppelt ist.

## Revendications

1. Circuit semiconducteur comprenant :
un transistor à effet de champ (1150, 1250, 1480, 1554, 1854) comprenant une pluralité de couches semiconductrices (1352, 1356, 1532, 1534, 1832, 1834) disposées sur un substrat,
une source (1158, 1258, 1326, 1462, 1830), un drain (1152, 1252, 1348, 1478, 1814) et une grille (1156, 1256, 1328, 1332, 1336, 1340, 1346, 1464, 1828, 1824, 1820, 1812) couplés électriquement aux couches semi-conductrices, et
une structure de distribution de charge à couplage de manière capacitive (1174, 1204) disposée sur les couches semi-conductrices, ladite structure de distribution de charge étant configurée pour produire une décharge de surface sur une partie de surface du transistor disposée entre la porte et le drain pendant un transitoire d'un état passant à un état bloqué et une recharge de surface sur ladite partie de surface pendant un transitoire de l'état bloqué à l'état passant ;
dans lequel la structure de distribution de charge a une pluralité de conducteurs avec un potentiel flottant ; et
un système de décharge statique (1102, 1202, 1402, 1552, 1852) supprimant la charge qui s'accumule sur au moins un sous-ensemble des conducteurs, ledit système de décharge statique supprimant la charge qui s'accumule sur le sous-ensemble de conducteurs lorsque le dispositif semiconducteur est dans un premier état tout en permettant à la charge de s'accumuler sur le sous-ensemble de conducteurs lorsque le dispositif semiconducteur est dans un second état.

2. Circuit semiconducteur selon la revendication 1, dans lequel ledit transistor à effet de champ a une vitesse de commutation cible de conception, ladite structure de distribution de charge étant en outre configurée pour produire la décharge de surface et se recharger à un taux supérieur à la vitesse de commutation cible de conception.

3. Circuit semiconducteur selon la revendication 1, dans lequel la structure de distribution de charge à couplage de manière capacitive comporte une grille métallique ayant une pluralité d'éléments allongés conducteurs disposés sur ladite partie de surface, lesdits éléments allongés conducteurs étant couplés de manière capacitive les uns aux autres.

4. Circuit semiconducteur selon la revendication 3, dans lequel la pluralité d'éléments allongés conducteurs définissent une structure se répétant périodiquement.

5. Circuit semiconducteur selon la revendication 3, dans lequel la pluralité d'éléments allongés conducteurs comporte un premier ensemble d'éléments allongés formés dans une première couche et un second ensemble d'éléments allongés formés dans une seconde couche, et éventuellement dans lequel les éléments allongés du premier ensemble d'éléments allongés sont parallèles les uns aux autres et les éléments allongés dans le second ensemble d'éléments allongés sont parallèles les uns aux autres.

6. Circuit semiconducteur selon la revendication 3, dans lequel la décharge de surface supprime de ladite partie de surface au moins environ 90 % d'une charge maximale établie sur ladite partie de surface, et éventuellement dans lequel la recharge de surface augmente la charge sur ladite partie de surface à au moins 90 % de la charge maximale.

7. Circuit semiconducteur selon la revendication 1, dans lequel :
le transistor à effet de champ est un dispositif semiconducteur haute tension à trois bornes, et éventuellement dans lequel le transistor à effet de champ est un HFET, par exemple un HFET en mode d'appauvrissement.

8. Circuit semiconducteur selon la revendication 2, dans lequel le système de décharge statique comporte une pluralité de transistors (1178, 1134, 1138, 1144, 1278, 1280, 1282, 1234, 1238, 1244) couplés entre la grille et un drain du dispositif semiconducteur.

9. Circuit semiconducteur selon la revendication 8, dans lequel une source d'un premier des transistors est couplée électriquement à une grille du deuxième des transistors et un drain du premier transistor est couplé électriquement à une grille d'un troisième des transistors, la source du premier transistor étant couplée électriquement à la source du dispositif semiconducteur et une grille du premier transistor étant couplée électriquement à la grille du dispositif semiconducteur.

10. Circuit semiconducteur selon la revendication 8, dans lequel chacun de la pluralité de transistors est agencé pour être dans un état bloqué lorsque le dispositif semiconducteur est dans un état bloqué et dans un état passant lorsque le dispositif semiconducteur est dans l'état passant.

11. Circuit semiconducteur selon la revendication 8, dans lequel chacun des transistors est configuré pour avoir une tension de claquage inférieure à une tension de claquage du transistor à effet de champ.

12. Circuit semiconducteur selon la revendication 8, dans lequel la source d'un transistor dans la pluralité de transistors dans le système de décharge statique est couplée à un premier conducteur de la pluralité de conducteurs de la structure de distribution de charge, la grille du transistor étant couplée à un second conducteur de la pluralité de conducteurs de la structure de distribution de charge, la différence de potentiel électrique entre le premier conducteur et le second conducteur étant suffisante pour maintenir le transistor dans un second état lorsque le dispositif semiconducteur est dans le second état.

13. Circuit semiconducteur selon la revendication 8, dans lequel la structure de distribution de charge comporte N conducteurs E1, E2, ... EN, où N > 1, la pluralité de transistors comportant N + 1 transistors Q1, Q2, ... QN + 1 tel que le conducteur EK est couplé électriquement à une source de transistor Q K + 1, une grille de transistor QK + 2 et un drain de transistor QK, où 1 <K ≤ (N-1).

14. Procédé de formation du circuit semiconducteur selon l'une quelconque des revendications 1 à 13, le procédé comprenant :
la formation du transistor à effet de champ (1150, 1250, 1480, 1554, 1854) comportant
la formation d'une première couche active sur un substrat,
la formation d'une seconde couche active sur la première couche active de telle sorte que les première et seconde couches actives sont à l'origine d'une couche bidimensionnelle de gaz d'électrons entre la première couche active et la seconde couche active,
la formation de contacts de source, de grille et de drain sur la seconde couche active, et
la formation de la structure de distribution de charge (1174, 1204) sur la seconde couche active entre les contacts de grille et de drain de telle sorte que la structure de distribution de charge est couplée de manière capacitive à un contact de grille.
